(19) Europäisches Patentamt
European Patent Office
Office européen des brevets

(11) **EP 3 485 284 B1**

(12) **FASCICULE DE BREVET EUROPEEN**

(45) Date de publication et mention de la délivrance du brevet:
**17.02.2021 Bulletin 2021/07**

(21) Numéro de dépôt: **17826730.8**

(22) Date de dépôt: **12.07.2017**

(51) Int Cl.:
*G01R 31/08* (2020.01)    *H02J 13/00* (2006.01)

(86) Numéro de dépôt international:
**PCT/CA2017/050847**

(87) Numéro de publication internationale:
**WO 2018/010028 (18.01.2018 Gazette 2018/03)**

(54) **DÉTECTION D'ANOMALIES DANS UN RÉSEAU ÉLECTRIQUE**

ERKENNUNG VON ANOMALIEN IN EINEM ELEKTRISCHEN NETZ

DETECTION OF ANOMALIES IN AN ELECTRICAL NETWORK

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **14.07.2016 CA 2936212**

(43) Date de publication de la demande:
**22.05.2019 Bulletin 2019/21**

(73) Titulaire: **Hydro-Québec**
**Montréal, QC H2Z 1A4 (CA)**

(72) Inventeurs:
- **LÉONARD, François**
  **Montréal**
  **Québec H1C 1B1 (CA)**
- **ZINFLOU, Arnaud**
  **Longueuil**
  **Québec J4N 0H1 (CA)**
- **BOUFFARD, Alexandre**
  **Saint-Bruno**
  **Québec J3V 4P4 (CA)**
- **VIAU, Mathieu**
  **Varennes**
  **Québec J3X 2J7 (CA)**

(74) Mandataire: **Plasseraud IP**
**66, rue de la Chaussée d'Antin**
**75440 Paris Cedex 09 (FR)**

(56) Documents cités:
| | |
|---|---|
| WO-A1-2012/045498 | WO-A1-2012/045498 |
| WO-A1-2015/130819 | WO-A1-2015/130819 |
| US-A1- 2013 076 534 | US-A1- 2013 076 534 |

**Description**

**DOMAINE DE L'INVENTION**

L'invention porte en général sur une méthode qui traite des mesures de consommation fournies par des compteurs intelligents présumés être rattachés à un même réseau basse tension, et notamment sur une méthode pour détecter des anomalies dans un réseau électrique, un système et un produit tangible et non transitoire de programme informatique exécutant la méthode. La méthode permet notamment de détecter et quantifier des non-conformités électriques (NCE) pouvant être présentes.

**CONTEXTE**

Les données transmises par des compteurs intelligents contiennent de l'information pouvant être utile pour effectuer une détection de NCE. Non seulement les mesures prises par les compteurs intelligents sont précises, synchronisées et abondantes, elles comprennent des mesures qui couvrent deux aspects pour analyser un modèle, soit l'input, un courant débité par un compteur, et l'output, une tension mesurée au compteur. Pour $I$ compteurs raccordés à un même transformateur, il est obtenu $I$ inputs et $I$ outputs, ce qui donne un système d'équations déterminé, en autant que la tension d'alimentation de ligne à laquelle est rattaché le transformateur basse tension est connue ou à tout le moins constante. Or, dans la réalité, la tension de ligne est inconnue, varie considérablement et rapidement. De plus, il peut y avoir des compteurs électromécaniques qui, rattachés au transformateur, font en sorte que le système d'équations est sous-déterminé pour caractériser le réseau du transformateur. Enfin, des NCE viennent aussi ajouter des inconnues au système d'équations. C'est pourquoi jusqu'ici, les méthodes et systèmes proposés ne peuvent prétendre générer un modèle de réseau basse tension suffisamment précis pour détecter et quantifier les NCE. Les brevets et demandes de brevets suivants donnent des exemples de méthodes et systèmes de détection de NCE proposés jusqu'ici: US20100007336 (de Buda), US20140236506 (Nikovski et al.), US20140368189 (Bernheim et al.), US20150241488 (Sonderegger), US20160035049 (Vinodini et al.), US20160054364 (Chen et al.), US20160117326 (Steigler), US2016320431 (Driscoll et al.), US6633823 (Bartone et al.), US7936163 (Lee), US7986246 (Angelis et al.), US8818742 (Ansari), US9013173 (Veillette), US9122618 (Hugues), WO2013086631 (Hughes) et WO2016049369 (Siebel et al.). Les brevets et demandes de brevets suivants donnent des exemples de méthodes et systèmes d'analyse de topologie proposés jusqu'ici: EP2869422 (Maximini et al.), US20090281679 (Taft et al.), US20140317258 (Riley), US20150149128 (Baone et al.), US20150278410 (Kumar et al.), US9094430 (Wang), US9189822 (Conant et al.), US9214836 (Flammer), US9285242 (Arya et al.), WO2014130366 (Hansell et al.), WO2014185921 (Marinakis), WO2015120141 (Shima) et WO2015130819 (Sonderreger).

**SOMMAIRE**

Selon une réalisation de l'invention, il est proposé une méthode mise en oeuvre par ordinateur pour détecter des anomalies dans un réseau électrique, la méthode comprenant les étapes de:

(i) récupérer des mesures de consommation produites par des compteurs présumés être rattachés à un même transformateur du réseau électrique d'après une topologie préétablie du réseau électrique, les mesures de consommation étant échelonnées dans le temps;
(ii) générer un modèle matriciel ohmique du réseau électrique, le modèle matriciel ohmique ayant pour input des courants transités par les compteurs, pour output des chutes de tension relative des compteurs référencées à une tension d'un noeud de référence situé sur le réseau électrique, et pour termes matriciels des grandeurs résistives déterminées initialement par des courants et des tensions basés sur les mesures de consommation, la tension relative étant une différence de tension entre une tension déterminée pour un des compteurs et une moyenne de tensions déterminées pour un ensemble de compteurs du réseau électrique;
(iii) effectuer aux moins une des opérations suivantes:

comparer les grandeurs résistives du modèle matriciel ohmique les unes aux autres selon des patrons de comparaison matricielle préétablis et par rapport à des seuils de grandeurs préétablies indicatifs d'anomalies; déterminer une chute de tension relative instantanée d'un compteur basée sur les mesures de consommation du compteur et déterminer des écarts par rapport à la chute de tension relative instantanée estimée avec le modèle matriciel ohmique pour le compteur, les écarts dépassant un seuil préréglé étant indicatifs d'anomalies; et générer un modèle matriciel inverse du modèle matriciel ohmique, le modèle matriciel inverse ayant pour input des écarts de chutes de tension relative instantanée des compteurs et pour output des courants non mesurés en fonction des écarts, les courants non mesurés dépassant un seuil préréglé étant indicatifs d'anomalies;

(iv) selon qu'une condition de modélisation préétablie du modèle matriciel ohmique est satisfaite ou non, retourner à l'étape (ii) en modifiant l'input et les grandeurs résistives en fonction des anomalies détectées à l'étape (iii); et

(v) fournir un diagnostic du réseau électrique caractérisant des anomalies détectées à l'étape (iii).

Selon d'autres réalisations de l'invention, il est proposé un système et un produit tangible et non transitoire de programme informatique exécutant la méthode énoncée ci-dessus.

Ce qui suit fournit un aperçu de certaines caractéristiques possiblement préférables de l'invention qui doivent être considérées de manière non restrictive et qui seront décrites plus en détails ci-après.

Selon une réalisation de la présente invention, la méthode peut être résumée de sorte qu'une mesure électrique est comparée à un résultat prédit par un modèle de réseau basse tension comprenant des compteurs raccordés au secondaire d'un même transformateur pour une détection de NCE. Au préalable, la méthode décrite dans la demande WO2017/100916 (Léonard et al.) pour mettre à jour une topologie du réseau par réattribution successive des compteurs peut être utilisée pour améliorer la véracité des liens d'appariements compteurs-transformateurs. Pour la modélisation du réseau, le problème de la variation de tension de ligne est résolu en comparant des écarts de mesures de tension électrique des compteurs par rapport à une tension moyenne instantanée obtenue de l'ensemble ou un sous-ensemble de compteurs tout en référençant les écarts de tension par rapport à un nœud de référence pouvant être, par exemple, un premier raccordement de compteur ou une première jonction de ligne selon la topologie du réseau. Le modèle caractérisant le réseau basse tension est une matrice ohmique aussi appelée matrice de fonction de transfert permettant entre autres de diagnostiquer une présence de NCE dans le réseau. La méthode détermine une matrice ohmique relative à partir de la matrice de fonction de transfert. Les termes de ces matrices ont pour unité des Ohms et ont leurs grandeurs déterminés par les caractéristiques électriques du réseau. La matrice ohmique relative peut être utilisée pour déterminer des chutes de tension relatives entre compteurs à partir des courants mesurés par les compteurs. Ces chutes de tension relatives, lorsqu'elles sont comparées aux chutes de tension déterminées selon les mesures des compteurs, donnent des écarts de différence de tension caractérisant un type de NCE pouvant être présent. Pour certains types de NCE, ces écarts sont aussi représentatifs de courants non mesurés par les compteurs. L'inverse de la matrice ohmique relative, soit un pseudo-inverse ou l'inverse de sa diagonale, multiplié par les écarts de tension entre les chutes de tension prédites par le modèle et les chutes de tension mesurées, donne une estimation des courants non mesurés. Une dispersion estimée pour chaque terme ou élément de la matrice de fonction de transfert donne une matrice de dispersion. Une visualisation de la matrice de dispersion permet de détecter et caractériser des NCE en donnant un indice de reproductibilité d'une réponse en tension des compteurs en fonction d'une modulation de charge de l'un d'eux. Une matrice de corrélation et une matrice de cohérence peuvent constituer d'autres moyens de caractérisation de NCE.

La méthode permet de détecter des NCE comme des erreurs d'appariement compteur-transformateur, un compteur défectueux, une présence de compteurs électromécaniques ou rattachements forfaitaires non-inscrits dans la base de données définissant une description topologique du réseau, des dérivations, des contournements, des rattachements défectueux ou points chauds. La modélisation d'une NCE caractérisée par un courant non mesuré peut se faire en ajoutant une estimation de ce courant en amont du calcul de la fonction de transfert, permettant ainsi de confirmer la modélisation selon une réduction d'un résidu de variation de tension entre la tension prédite par le modèle pour un compteur et la tension mesurée par le compteur.

**DESCRIPTION BRÈVE DES DESSINS**

Une description détaillée des réalisations préférées de l'invention sera donnée ci-après en référence avec les dessins suivants:

Figure 1 est un diagramme schématique illustrant une dérivation en amont d'un compteur.

Figure 2 est un diagramme schématique illustrant un contournement d'un compteur.

Figure 3 est un diagramme schématique illustrant un problème de raccordement aérien ou de point chaud dans l'embase de connexion d'un compteur.

Figure 4 est un diagramme schématique unifilaire d'un réseau de distribution basse tension où un transformateur est raccordé à des clients, dont un présente une anomalie.

Figures 5A et 5B sont des diagrammes schématiques unifilaires illustrant deux exemples de ligne de distribution basse tension avec raccordement à un transformateur en bout de ligne et interposé entre des compteurs, respectivement.

Figure 6 est un graphe illustrant un exemple de matrice de fonction de transfert.

Figure 7 est un graphe illustrant une matrice ohmique relative correspondant à la matrice de fonction de transfert illustrée à la Figure 6.

Figure 8 est un graphe illustrant un exemple de matrice de fonction de transfert obtenue pour 5 compteurs où le dernier n'est en réalité pas rattaché au même transformateur que les quatre autres compteurs.

Figures 9A et 9B sont des graphes illustrant un exemple de matrice de fonction de transfert obtenue pour 3 compteurs, sans et avec augmentation proportionnelle du courant mesuré par le compteur #1.

Figures 10 est un graphe illustrant un exemple de matrice de fonction de transfert obtenue pour 43 compteurs où trois anomalies apparaissent.

Les Figure 11A et 11B donnent respectivement un exemple de matrice de cohérence et un exemple de matrice de dispersion relative de la fonction de transfert d'un même cas où le compteur #3 est vu comme une NCE probable.

Figures 12A et 12B sont deux graphes illustrant, respectivement, la différence $\Delta\Delta v_{i,m}$ entre la tension relative mesurée et la tension relative prédite pour un compteur ayant un point chaud, et le courant mesuré et l'estimation du courant non mesuré pour ce compteur.

Figure 13 est un diagramme schématique illustrant un exemple d'interface utilisateur graphique affichant un cas de subtilisation massive par dérivation pour une serre de production de marihuana.

Figure 14 est un organigramme schématique illustrant des étapes de la méthode selon une réalisation de l'invention.

Figure 15 est un diagramme schématique illustrant un exemple de système pouvant réaliser la méthode selon l'invention.

## DESCRIPTION DÉTAILLÉE DES RÉALISATIONS PRÉFÉRÉES

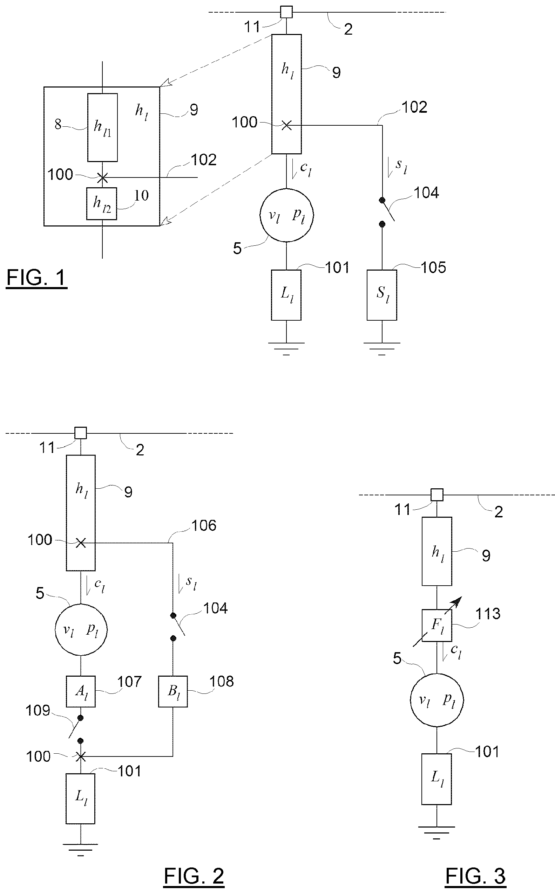

Dans le cadre de cette divulgation, pour fin de simplification, un réseau de distribution biphasé à trois fils dont un neutre ("split-phase") est représenté par un circuit unifilaire. En référence aux Figures 1, 2 et 3, il est montré des exemples d'anomalies électriques attribuables à des NCE.

En référence à la Figure 1, un compteur 5 est rattaché via une jonction de raccordement 11 à une ligne basse tension 2 par un câble de raccord d'une résistance $h_l$ 9 et alimentant une charge $L_l$ 101. Une dérivation 102 en amont du compteur 5 peut être réalisée par un branchement 100 plus proche du compteur 5 que de la ligne 2 de sorte qu'une valeur de résistance entre le branchement 100 et la ligne 2 est moindre que la valeur $h_l$ 9. La résistance $h_l$ 9 se divise en une résistance $h_{l1}$ 8 entre le branchement 100 et le réseau 2 et en une résistance $h_{l2}$ 10 entre le branchement 100 et le compteur 5 de sorte que $h_l = h_{l1} + h_{l2}$ tel qu'illustré dans le détail à gauche dans la Figure 1. La dérivation 102 alimente une charge $S_l$ 105 indépendante de la charge 101 alimentée par le compteur 5 et peut être commutée par un commutateur 104 ou par un retrait/mise en place du branchement 100.

En référence à la Figure 2, un contournement 106 du compteur 5 peut être réalisé par deux branchements 100, avant et après le compteur 5 de sorte qu'un résistance $B_l$ 108 entre les branchements 100 est faible et que la résistance $h_{l2}$ 10 (comme illustré à la Figure 1) entre le branchement de contournement 100 coté ligne basse tension 2 et le compteur 5 est usuellement négligeable en regard de $h_{l1}$ 8 (comme illustré à la Figure 1) car le plus souvent le branchement 100 en question est localisé dans l'embase (non illustrée) supportant le compteur 5. Le contournement 106 alimente conjointement la charge $L_l$ 101 avec le compteur 5 et peut être commuté par un commutateur 104 ou par un retrait/mise en place de l'un des branchements 100 ou des deux branchements 100. Le compteur 5 peut aussi être commuté à sa sortie par un commutateur 109. Lorsque les deux commutateurs 104, 109 sont fermés, le rapport $(h_{12}+A_l)/B_l$ détermine un ratio courant de contournement sur courant mesuré par le compteur 5, où $A_l$ 107 représente une valeur de résistance entre le commutateur 109 et le compteur 5.

En référence à la Figure 3, un problème de raccordement peut, entre autres, provenir d'un branchement défectueux, d'un point chaud dans une connexion supérieure du compteur 5 à son embase (non illustrée) ou d'un coupe-circuit (non illustré) du compteur 5 qui s'est dégradé. Le problème de raccordement peut aussi trouver son origine dans des moyens de subtilisation qui sont défaillants. Ce type de défaut peut être caractérisé par une résistance variable $F_l$ 113 aux bornes de laquelle apparaît une chute de tension variable. Pouvant être sensible au vent, à la température ou à la charge, ce type d'anomalie peut être rapporté pour des raisons de sécurité et de continuité de service.

Les cas décris aux Figures 1, 2 et 3 peuvent être combinés ensemble.

Le tableau 1 ci-dessous énumère des mesures (grandeurs électriques) utiles pour réaliser l'invention.

Tableau 1

| Descriptif de la mesure | Symbole | Unité |
|---|---|---|
| Estampille temporelle | $t_m$ | AAAA,MM,JJ,HH,MM,SS |
| Moyenne de la tension efficace | $v_m$ | Volts |
| Énergie consommée | $E_m$ | kW-h |
| Facteur de puissance (optionnel) | $\lambda_m$ | adimensionnel |

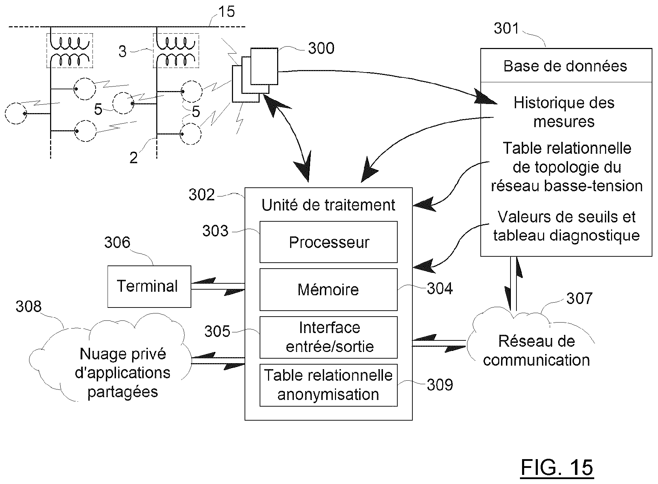

En référence à la Figure 15, il est illustré un exemple de système selon l'invention. Les compteurs intelligents 5 interrogés sur le réseau 2 intègrent la puissance active et réalisent un calcul de la moyenne de la tension efficace sur un intervalle typiquement de 15 minutes et transmettent le résultat, soit l'énergie *E* et la tension efficace *v* pour chaque compteur 5 à une base de données 301. L'estampille temporelle correspond au moment de la fin de la période d'intégration de la mesure. Dans le cas d'un réseau de distribution biphasé à trois fils dont un neutre ("split-phase"), les compteurs 5 ne transmettent usuellement pas les valeurs mesurées correspondant à chaque tension phase-neutre mais transmettent un ensemble de valeurs équivalent à un réseau simple phase ("single-phase").

L'invention est décrite ci-après pour un réseau de distribution qui ne comprend que des sites de consommation d'énergie. L'invention peut néanmoins être adaptée pour un réseau de distribution comprenant une mixité de consommation et de production d'énergie.

La méthode selon l'invention fonctionne avantageusement pour un intervalle d'intégration de 15 minutes ou plus court. Un intervalle plus long d'intégration est susceptible de réduire l'information véhiculée par l'impact des commutations aléatoires des appareils reliés au réseau 2 sur les tensions mesurées. Avec une interrogation à l'heure, les profils de courant des différents compteurs 5 pourraient ne pas être assez dissimilaires pour caractériser l'impact sur le réseau 2 de la consommation de chaque client.

Le courant d'un compteur "*i*" pour une estampille temporelle $t_m$ peut se calculer, par exemple, à partir des mesures tel que

$$c_{i,m} = \frac{p_{i,m}}{v_{i,m}} \cdot \frac{1}{\lambda_{i,m}} \ , \tag{1a}$$

avec la puissance active

$$p_{i,m} = E_{i,m} \cdot \frac{3600 \text{ s}}{\Delta t} \cdot \frac{1000 \text{ W-h}}{1 \text{ kW-h}}, \text{ où } \Delta t \text{ représente l'intervalle d'intégration exprimé en secondes.} \tag{1b}$$

Dépendamment de la méthode de calcul de la tension efficace utilisée par le compteur, un débalancement de charge entraînant un courant de neutre important pour un réseau biphasé introduira un biais dans les calculs proposés aux équations 1a et 1b. De plus, le facteur de puissance est modulé par le type d'équipement domiciliaire (ou autre) commuté et varie donc dans le temps pour chaque compteur. Une variation relative du facteur de puissance par rapport à sa moyenne peut être négligée pour des équipements tels des réfrigérateurs et congélateurs car ils présentent un profil uniforme et relativement constant d'utilisation. Par contre, des pompes à chaleur pour le chauffage ou la climatisation perturbent le facteur de puissance en introduisant des fluctuations de quelques pourcents dans l'estimation du courant selon l'équation 1a si le facteur de puissance est inconnu. Concernant les clients industriels, une commutation d'équipements électriques réactifs (inductif ou capacitif) comme une station de soudage module occasionnellement significativement le facteur de puissance de l'installation. Lorsque le facteur de puissance est inconnu, il peut être fixé à une même valeur plausible pour tous les compteurs et cette valeur sera constante dans le temps. Si $\lambda_{i,m} = 1$, le courant calculé de la sorte est légèrement sous-estimé car la tension $v_i$ est surévaluée en raison de la contribution de la puissance réactive à cette tension. Les grandeurs ohmiques sont surestimées. Ces sous-estimations et surestimations n'ont pas de réelle importance dans le calcul d'écarts de chute de tension où le calcul de l'estimation de chute de tension est fait par le produit des grandeurs ohmiques par les courants, la sous-estimation de l'un compensant la surestimation de l'autre. Dans les calculs qui suivent, le facteur de puissance est fixé unitaire, et la composante réactive des compteurs de même que son addition sur le réseau basse tension ne sont pas considérées.

En Amérique du Nord, les compteurs demi-phase sont rattachés à une des polarités et au neutre ayant ainsi une alimentation 125 V. Ces compteurs demi-phase alimentent usuellement un fournisseur de service en communication. Un algorithme détecte ce genre de situation par une tension mesurée correspondant à la demi-tension de la phase. La tension d'un compteur demi-phase doit alors se situer entre deux seuils minimum et maximum typiquement fixés respectivement à 45% et 55% de la tension de phase. La donnée peut être écartée car ces clients consomment usuellement peu de puissance. Sinon, la tension mesurée par le compteur peut être doublée de sorte que le courant résultant sera deux fois moindre, ce qui ne biaise pas la modélisation. En effet, dans la réalité, un courant est multiplié par une demi-tension alors que dans la modélisation, un demi-courant est multiplié par la pleine tension. Dans les deux cas, la chute de tension relative observée sur la phase est identique.

Selon une réalisation de la méthode selon l'invention, le calcul des quantités tension et courant pour chaque estampille temporelle est suivi d'une étape de qualification des quantités pour écarter celles qui apparaissent invalides. Par exemple, toutes les données associées à une estampille temporelle sont de préférence écartées d'un traitement ultérieur lorsqu'une des données associée à l'estampille considérée exhibe une valeur aberrante. Par exemple, une valeur aberrante peut découler d'une erreur de communication ou d'une erreur d'écriture dans la base de données 301 emmagasinant les données transmises par les compteurs intelligents 5. Pour d'autres types de motifs d'invalidité, les données peuvent ne pas être écartées de la totalité du traitement. Ces données peuvent être écartées du calcul de modélisation tout en étant conservée pour affichage et calculs d'écart entre le prédictif et le réel. Dans une réalisation possible de l'invention, un vecteur *masque(m)* peut être utilisé de manière à avoir un état "vrai" comme valeur par défaut et être mis à "faux" pour des estampilles temporelles correspondant à des données invalides. Par exemple, trois types de motif d'invalidation de données peuvent être qualifiés: les pannes de courant et surtension, qui sont regroupés sous un même motif "d'anomalie de tension"; les "pertes de synchronisation de communication entre compteurs"; et les "événements divers non qualifiables". Une anomalie de tension est détectée par exemple lorsque la tension d'un certain nombre de compteurs apparaît en dessous d'un seuil minimal ou au-dessus d'un seuil maximal fixé en absolu ou fixé proportionnellement à la tension moyenne observée sur une cohorte de compteurs rattachés à un même transformateur. Typiquement, le seuil de basse tension peut être ajusté à 90% de la tension moyenne observée sur tous les compteurs pour la durée, et le seuil de surtension peut être ajusté à 115%. Une panne de courant présente pour moins de 5% du temps dans l'intervalle d'intégration (e.g. de 5 ou 15 minutes) de la mesure prise par un compteur peut ne pas être détectée par un dépassement de seuil de 90%. Aussi, il se peut qu'une perturbation électrique se situe temporellement à une frontière de deux intervalles d'intégration et ne soit décelée que pour un des deux intervalles. Par précaution, les données situées avant et celles situées après un intervalle où le dépassement est observé sont de préférence aussi retirées du lot à traiter ultérieurement, c'est-à-dire que le vecteur *masque(m)* a des valeurs mises à "faux" de part et d'autres de la zone où une panne/surtension est décelée. Des pertes de synchronisation des compteurs surviennent lors d'un rétablissement de la communication suite à une panne de courant, d'une modification matérielle ou peuvent être diverses et accidentelles. Une comparaison entre les différentes mesures de tension permet de quantifier les écarts temporels entre les profils de tension et les estampilles temporelles qui leurs sont attribuées. En première approximation, si les pertes de conduction sont négligées, la tension est déterminée par la tension de sortie du transformateur et apparaît donc relativement similaire d'un compteur à l'autre. C'est la fluctuation de cette tension qui peut être avantageusement corrélée ici comme "code barres" entre les lectures de compteur afin de déterminer une correspondance temporelle, dite en synchronisme, des mesures des compteurs. Au cas où les données sont faussement horodatées pour quelques estampilles avant et après détection d'une perte de synchronisation, par précaution, les données ayant une estampille avant, une estampille pendant et une estampille après détection d'une perte de synchronisation sont de préférence retirées. La correspondance temporelle peut être effectuée dans la même étape que celle d'une détection des tensions anormales ou dans une autre étape, avant ou après. La détection et le retrait de données découlant d'événements divers non qualifiables (e.g. fluctuation anormale de la tension, reconfiguration temporaire pour travaux sur le réseau, accident routier, feu et défaut électrique dans un domicile, etc.) permet d'accroître la précision de la modélisation. Dans une réalisation de l'invention impliquant une première utilisation d'un modèle appliqué à une prédiction des chutes de tension en fonction des courants mesurés, les écarts au modèle sont considérés pour chaque intervalle temporel. La méthode écarte d'un second calcul de la matrice de fonction de transfert les données correspondant à des prédictions trop différentes des mesures. Typiquement, un seuil d'écart maximal peut être fixé manuellement ou déterminé de façon à éliminer de 1% à 5% des données. Cette fonctionnalité peut être activée ou non.

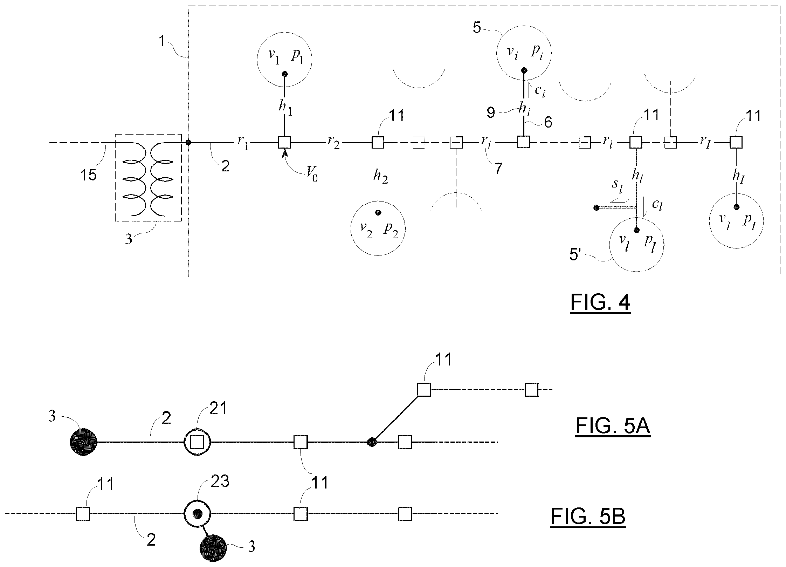

En référence à la Figure 4, il est illustré un circuit unifilaire équivalent d'un réseau de distribution basse tension 1 raccordé à un transformateur 3 et reliant par une ligne 2 des compteurs 5 où s'effectuent des mesures de tension $v_i$ et de consommation $p_i$. Les segments raccordant les équipements sont considérés résistifs de sorte que les segments de la ligne 2 entre des jonctions de raccordement 11 des compteurs 5 à la ligne 2 sont représentés avec des résistances 7 $[r_1, r_2, ..., r_i, ..., r_k, ..., r_l]$ alors que les segments entre les compteurs 5 et les jonctions de raccordement 11 sont représentés pas des résistances de rattachement 9 $[h_1, h_2, ..., h_i, ..., h_k, ..., h_l]$. En pointillé dans la Figure 4, un nombre quelconque de compteurs rattachés à des segments de ligne peuvent être retiré ou ajouté à cet exemple de réseau. Sur le réseau 1, il y a $I$ compteurs (clients) et il est représenté de façon simplifiée une anomalie sous forme d'un cas de raccordement non conforme proche du compteur 5' du client $I$ en ligne doublée.

La tension mesurée par le compteur $i$ sur le réseau basse tension 1 est donnée par

$$v_i = V_0 - c_i \cdot h_i - \left( \sum_{j=2}^{i} \left( c_j \cdot \sum_{k=2}^{j} r_k \right) \right) - \left( \sum_{j=i+1}^{I} c_j \right) \cdot \left( \sum_{k=2}^{i} r_k \right) \qquad (2)$$

où: $V_0$ représente la tension à un noeud de référence pouvant être, par exemple, le premier raccordement de compteur 21 (comme illustré à la Figure 5A) ou la première jonction de ligne 23 (comme illustré à la Figure 5B); $c_i$ représente le courant en ampères attribuée au compteur $i$; $h_i$ représente la résistance 9 du raccordement 6 du compteur $i$ à la ligne basse tension 2; $r_i$ représente la résistance 7 du conducteur sur la section de ligne de $i$ à $i$-1; et $I$ représente le nombre total de compteurs raccordés à la ligne.

La résistance $r_1$ est absente de la formulation exprimée à l'équation 2 puisque que cette résistance est située en amont du noeud correspondant à la tension de référence $V_0$ de sorte que pour cet exemple de réseau, $v_1 = V_0 - c_1 \cdot h_1$

pour le premier compteur, $v_2 = V_0 - c_2 \cdot h_2 - c_2 \cdot r_2 - \left( \sum_{j=i+1}^{I} c_j \right) \cdot r_2$ pour le second compteur en aval et ainsi de suite. Dans l'équation 2, si $i$ correspond au dernier compteur de la ligne 2, le terme de droite disparaît puisque $i = I$.

Dans le système linéaire $v_i = f(V_0, c_0, c_1, \cdots, c_i, \cdots, c_I)$ présenté à l'équation 2, il y a $I$ résistances $h_i$, $I$ résistances $r_k$, $I$ variables indépendantes $c_i$, $I$ variables dépendantes $v_i$ et une inconnue $V_0$. Les résistances sont des valeurs inconnues du système et définissent le modèle du réseau basse tension. Dans un premier temps, ces résistances sont considérées constantes en négligeant des influences de charge, de température, de vieillissement, de mauvais raccords et de points chauds.

Soit un courant non mesuré $s_l$ au compteur $I$ (5') alors

$$v_i\big|_{i>l} = V_0 - c_i \cdot h_i - \left( \sum_{j=1}^{i} \left( c_j \cdot \sum_{k=1}^{j} r_k \right) \right) - \left( \sum_{j=i+1}^{I} c_j \right) \cdot \left( \sum_{k=1}^{i} r_k \right) - s_l \cdot \sum_{k=1}^{l} r_k \,, \qquad (3a)$$

$$v_i\big|_{i<l} = V_0 - c_i \cdot h_i - \left( \sum_{j=1}^{i} \left( c_j \cdot \sum_{k=1}^{j} r_k \right) \right) - \left( \sum_{j=i+1}^{I} c_j \right) \cdot \left( \sum_{k=1}^{i} r_k \right) - s_l \cdot \sum_{k=1}^{i} r_k \qquad (3b)$$

$$v_l = V_0 - c_l \cdot h_l - \left( \sum_{j=1}^{l} \left( c_j \cdot \sum_{k=1}^{j} r_k \right) \right) - \left( \sum_{j=l+1}^{I} c_j \right) \cdot \left( \sum_{k=1}^{l} r_k \right) - s_l \cdot \sum_{k=1}^{l} r_k - s_l \cdot h_{i1} \,. \qquad (3c)$$

Toutes les tensions sont affectées par ce courant non mesuré et plus particulièrement la tension $v_l$ du compteur 5' contourné par ce courant. En connaissant les valeurs de résistances et la tension $V_0$, une anomalie peut ainsi être détectée et même être quantifiée. Dans la description qui suit, le précédent système d'équations est manipulé afin de le généraliser pour tout réseau basse tension. Il est proposé un moyen simple d'obtenir une première estimation des valeurs résistives et le système d'équations est référé sur la tension moyenne instantanée obtenue d'après les mesures des compteurs afin d'éliminer $V_0$, l'inconnue restante.

L'équation 2 est reformulée en prenant pour variables indépendantes les courants calculés de l'équation la et pour variables dépendantes les $v_i$. Avec le déplacement de la variable $V_0$, le système matriciel d'équations (rangée $i$, colonne $j$) suivant est alors obtenu:

$$\left[\begin{bmatrix} 0 & 0 & \cdots & 0 & \cdots & 0 \\ 0 & r_2 & \cdots & r_2 & \cdots & r_2 \\ \vdots & \vdots & \ddots & \vdots & \vdots & \vdots \\ 0 & r_2 & \cdots & \displaystyle\sum_{k=2}^{i} r_k & \cdots & \displaystyle\sum_{k=2}^{i} r_k \\ \vdots & \vdots & \vdots & \vdots & \ddots & \vdots \\ 0 & r_2 & \cdots & \displaystyle\sum_{k=2}^{j} r_k & \cdots & \displaystyle\sum_{k=2}^{I} r_k \end{bmatrix} + \begin{bmatrix} h_1 & & & & \\ & h_2 & & 0 & \\ & & \ddots & & \\ & & & h_i & \\ & 0 & & & \ddots \\ & & & & & h_I \end{bmatrix}\right] \cdot \begin{bmatrix} c_1 \\ c_2 \\ \vdots \\ c_i \\ \vdots \\ c_I \end{bmatrix} = \begin{bmatrix} V_0 - v_1 \\ V_0 - v_2 \\ \vdots \\ V_0 - v_i \\ \vdots \\ V_0 - v_I \end{bmatrix}. \tag{4}$$

Si ce système matriciel d'équations est valide pour le réseau illustré à la Figure 4, il ne l'est pas nécessairement pour d'autres configurations de réseau. Cependant, la même mécanique d'équations peut être développée et appliquée pour différentes configurations d'arborescence de réseau telles celles illustrées aux Figures 5A et 5B.

La formulation généralisée qui suit peut être étendue à tout réseau de type arborescent comprenant $I$ compteurs:

$$\left[\begin{bmatrix} r_{1,1} & r_{1,2} & \cdots & r_{1,i} & \cdots & r_{1,I} \\ r_{2,1} & r_{2,2} & \cdots & r_{2,i} & \cdots & r_{2,I} \\ \vdots & \vdots & \ddots & \vdots & \vdots & \vdots \\ r_{i,1} & r_{i,2} & \cdots & r_{i,i} & \cdots & r_{i,I} \\ \vdots & \vdots & \vdots & \vdots & \ddots & \vdots \\ r_{I,1} & r_{I,2} & \cdots & r_{I,i} & \cdots & r_{I,I} \end{bmatrix} + \begin{bmatrix} h_1 & & & & \\ & h_2 & & 0 & \\ & & \ddots & & \\ & & & h_i & \\ & 0 & & & \ddots \\ & & & & & h_I \end{bmatrix}\right] \cdot \begin{bmatrix} c_1 \\ c_2 \\ \vdots \\ c_i \\ \vdots \\ c_I \end{bmatrix} = \begin{bmatrix} V_0 - v_1 \\ V_0 - v_2 \\ \vdots \\ V_0 - v_i \\ \vdots \\ V_0 - v_I \end{bmatrix} \tag{5}$$

ou, sous forme simplifiée:

$$\left[\mathbf{R} + \mathbf{h}\right] \cdot \mathbf{C} = \Delta\mathbf{V} \tag{6}$$

où **R** est une matrice de résistances de segments de ligne basse tension et **h** est une matrice diagonale de résistances de raccordement. Ces matrices contiennent les grandeurs résistives caractérisant le réseau alors que le vecteur **C** contient les courants mesurés (e.g. calculés d'après les mesures fournies par les compteurs). Le vecteur $\Delta\mathbf{V}$ contient les écarts entre la tension commune $V_0$ qui est inconnue et les tensions mesurées par les compteurs. Le vecteur $\Delta\mathbf{V}$ contient des grandeurs positives puisque, en absence de production distribuée d'énergie chez les consommateurs, $V_0 \geq v_i$. Ces grandeurs positives correspondent à la chute de tension de ligne du noeud $V_0$ jusqu'à chaque compteur.

Dans la description qui suit, l'ensemble des mesures énumérées au tableau 1 regroupant les $I$ compteurs d'un réseau sera appelé "groupe de mesures" pour une estampille temporelle d'indice "$m$". Pour un ensemble de $M$ groupes de mesures qui peuvent être successifs ou discontinus:

$$\mathbf{Z} \cdot \mathbf{C}_m = \Delta\mathbf{V}_m \tag{7a}$$

avec

$$\mathbf{Z} = \left[\mathbf{R} + \mathbf{h}\right] = \begin{bmatrix} \ddots & \vdots & \cdot \\ \cdots & z_{i,j} & \cdots \\ \cdot & \vdots & \ddots \end{bmatrix} \tag{7b}$$

où **Z** est une matrice ohmique, $\mathbf{C}_m = [c_{1,m}, \cdots, c_{j,m}, \cdots, c_{J,m}]$ est un vecteur des courants de compteurs avec $c_{1,m} \geq 0$, et $\Delta\mathbf{V}_m = [V_{0,m}\text{-}v_{1,m}, \cdots, V_{0,m}\text{-}v_{j,m}, \cdots, V_{0,m}\text{-}v_{J,m}]$ est un vecteur des chutes de tension observées aux différents compteurs pour le groupe de mesures $m$. $\Delta \mathbf{V}_m = [0,...,0,...,0]$ pour $\mathbf{C}_m = [0,\cdots,0,\cdots,0]$ de telle sorte qu'en absence de charge, c'est la tension $V_{0,m}$ qui est mesurée par tous les compteurs. Une propriété particulière de la matrice ohmique $\mathbf{Z}$ est qu'elle est symétrique, soit $z_{i,j} = z_{j,i}$.

Selon l'hypothèse linéaire de la loi d'Ohm concernant la relation de tension aux bornes d'une résistance parcourue par un courant, la dérivée

$$\partial\left(\mathbf{Z}\cdot\mathbf{C}_m\right) = \partial\left(\Delta\mathbf{V}_m\right) \qquad (8a)$$

donne, quel que soit le courant,

$$\mathbf{Z}\cdot\partial\mathbf{C}_m = \partial\Delta\mathbf{V}_m \qquad (8b)$$

soit

$$\mathbf{Z}\cdot\begin{bmatrix} \partial c_{1,m} \\ \partial c_{2,m} \\ \vdots \\ \partial c_{i,m} \\ \vdots \\ \partial c_{I,m} \end{bmatrix} = \begin{bmatrix} \partial V_{0,m} - \partial v_{1,m} \\ \partial V_{0,m} - \partial v_{2,m} \\ \vdots \\ \partial V_{0,m} - \partial v_{i,m} \\ \vdots \\ \partial V_{0,m} - \partial v_{I,m} \end{bmatrix} \qquad (8c)$$

Pour une mesure de tension d'un compteur $i$ correspondant à l'estampille temporelle d'indice $m$, les équations 7b et 8c donnent

$$\partial v_{i,m} = \partial V_{0m} - \sum_j z_{i,j}\cdot\partial c_{j,m} \qquad (9)$$

où

$$\partial c_{j,m} = c_{j,m} - c_{j,m-1} \qquad (10)$$

représente la série temporelle des dérivées discrètes sur le courant et

$$\partial v_{i,m} = v_{i,m} - v_{i,m-1} \qquad (11)$$

représente la série temporelle des dérivées discrètes sur la tension. La série temporelle

$$\partial V_{0m} = V_{0m} - V_{0m-1} \qquad (12)$$

des dérivées de la tension à la sortie du transformateur est inconnue.

$$H_{i,j} = -\frac{\sum_{m=1}^{M} \partial v_{i,m}\cdot\partial c_{j,m}}{\sum_{m=1}^{M} \partial c_{j,m}^2} \qquad (13a)$$

est un exemple d'estimation de la fonction de transfert entre les *I* dérivées de courant et les *I* dérivées de tension pour un terme de la matrice de fonction de transfert

$$\mathbf{H} = \begin{bmatrix} \ddots & \vdots & \cdot \\ \cdots & H_{i,j} & \cdots \\ \cdot & \vdots & \ddots \end{bmatrix} . \tag{13b}$$

La fonction de transfert **H** peut être précisée davantage comme décrit plus loin. Le signe négatif dans la formulation de l'équation 13a fait en sorte que les termes $H_{i,j}$ ont une valeur positive comme espérance mathématique puisque, pour une charge résistive en aval du compteur $j$, la dérivée en tension vue par tout compteur $i$ est négative pour une augmentation du courant. La matrice de fonction de transfert a pour unité des Ohms et elle constitue une matrice ohmique caractérisant le réseau. La robustesse de l'estimation de fonction de transfert tient à ce qu'il n'y a pas d'inversion matricielle ou autre calcul pouvant mener à une singularité. La seule division pouvant être nulle est celle par la somme des carrés de dérivée de courant sur tous les compteurs. La probabilité que cette somme de carrés soit nulle est faible et correspond à un circuit ouvert chez tous les clients.

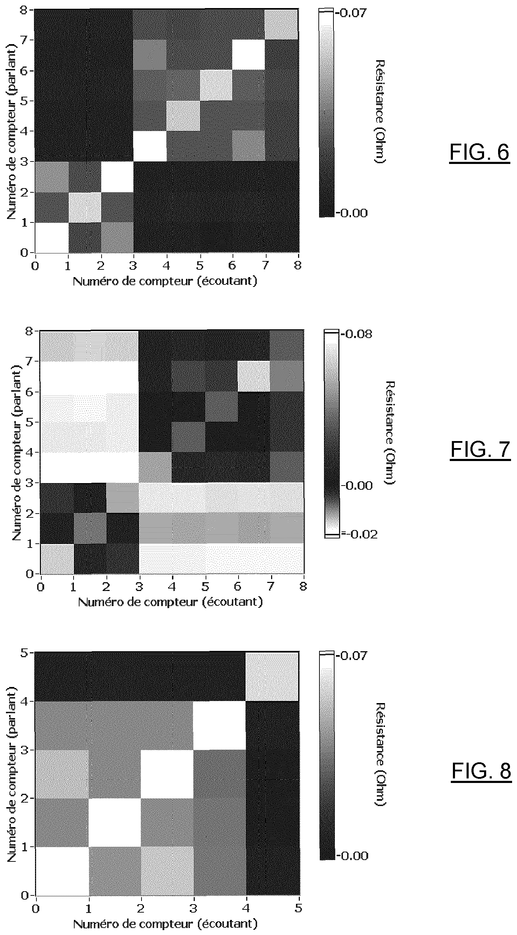

En référence à la Figure 6, il est illustré un exemple de matrice de fonction de transfert où, par le hasard de la numérotation des compteurs, il appert que le transformateur est rattachée au 3/8 du parcours d'une ligne basse tension avec les compteurs 0-2 d'un côté et les compteurs 3-7 de l'autre. Il y a apparence de symétrie de part et d'autre de la diagonale pour cet exemple.

En introduisant l'équation 9 dans l'équation 13a:

$$H_{i,j} = \frac{\sum_{m=1}^{M} \left( \partial V_{0m} + \sum_{n} z_{i,n} \cdot \partial c_{n,m} \right) \cdot \partial c_{j,m}}{\sum_{m=1}^{M} \partial c_{j,m}^2} \tag{14a}$$

soit

$$H_{i,j} = \frac{\left( \sum_{m=1}^{M} \partial V_{0m} \cdot \partial c_{j,m} \right)}{\sum_{m=1}^{M} \partial c_{j,m}^2} + \frac{\left( \sum_{n} z_{i,n} \sum_{m=1}^{M} \partial c_{j,m} \cdot \partial c_{n,m} \right)}{\sum_{m=1}^{M} \partial c_{j,m}^2} \tag{14b}$$

en dissociant les termes. Le terme de droite correspond à une résistance commune $Z_0$ à tous les compteurs, soit la résistance située en amont du réseau. En supposant des courants non-corrélés entre les compteurs, statistiquement ce terme tend ($\Rightarrow$) vers la résistance commune, soit

$$-\frac{\sum_{m=1}^{M} \partial V_{0m} \cdot \partial c_{j,m}}{\sum_{m=1}^{M} \partial c_{j,m}^2} \Rightarrow Z_0, \ \forall j, \tag{15}$$

avec les termes de la fonction de transfert définis par

$$H_{i,j} \Rightarrow Z_0 + z_{i,j}, \ \forall i,j. \tag{16}$$

La grandeur de résistance commune $Z_0$ est la somme de la résistance de ligne à partir de la source en amont du transformateur (rapportée selon le ou les rapports de transformation) avec la résistance du transformateur et la résistance entre le transformateur et le noeud de référence. La valeur estimée de la fonction de transfert obtenue avec l'expression 13a est d'autant plus proche de celle donnée à la droite de l'expression 16 que les courants mesurés entre compteurs ne corrèlent pas significativement en regard de leur variabilité d'amplitude dans le temps. Les compteurs qui présentent peu de consommation auront des valeurs très imprécises dans la rangée (indice $j$) de la matrice $\mathbf{H}$ de fonction de transfert. En contrepartie, comme peu de courant parcourt leur raccordement, ces mêmes compteurs seront d'excellents moyens de mesure de tension et donneront des valeurs plus précises dans la colonne (indice $i$) de la matrice $\mathbf{H}$ de fonction de transfert. Comme la matrice de fonction de transfert tends vers une matrice symétrique, soit $H_{j,i}$ un terme hors-diagonal peut être utilisé pour corriger le terme $H_{i,j}$ opposé par symétrie.

La valeur estimée de la fonction de transfert obtenue avec l'expression 13a présente des artefacts statistiques générés par l'intercorrélation entre un courant et les autres courants et aussi entre un courant et la tension de la ligne régulée en amont du transformateur. La température des conducteurs et la modulation du facteur de puissance en fonction des habitudes de consommation influencent aussi l'estimation de la fonction de transfert. Différentes techniques d'amélioration de l'estimation de la fonction de transfert sont possibles comme vu plus loin.

De l'équation 16 sont déduits les coefficients résistifs

$$z_{i,j} \cong H_{i,j} - Z_0 \tag{17}$$

de la matrice ohmique généralisée $\mathbf{Z}$ avec la résistance commune $Z_0$, une constante résistive inconnue. La résistance commune a une valeur proche des plus petites valeurs parmi les termes estimés de la matrice de fonction de transfert. La relation courant-tension donnée à l'équation 6 se réécrit alors:

$$\Delta \mathbf{V} \cong \mathbf{Z} \cdot \mathbf{C} \text{ avec } \mathbf{Z} = \begin{bmatrix} \ddots & \vdots & \iddots \\ \cdots & H_{i,j} - Z_0 & \cdots \\ \iddots & \vdots & \ddots \end{bmatrix} \text{ et où} \tag{18a}$$

$$\Delta \mathbf{V} = \begin{bmatrix} V_{0m} - v_{1,m}, \cdots, V_{0m} - v_{j,m}, \cdots, V_{0m} - v_{J,m} \end{bmatrix}, \tag{18b}$$

ce qui donne

$$V_{0m} - \sum_j \left( H_{i,j} - Z_0 \right) \cdot c_{j,m} \Rightarrow v_{i,m} \tag{19}$$

comme relation avec la tension mesurée au compteur $i$. Une estimation de tension instantanée obtenue avec le modèle est donnée par

$$v'_{i,m} = V_{0m} - \sum_j \left( H_{i,j} - Z_0 \right) \cdot c_{j,m} \tag{20}$$

tel que $v'_{i,m} = V_{0m}$ lorsque $c_{i,m} = 0$ et $v'_{i,m} < V_{0m}$ lorsque $\{\forall_{i,m} | c_{i,m} > 0\}$.

L'écart entre la tension instantanée du compteur $i$ et la tension moyenne des compteurs

$$\Delta v_{i,m} = v_{i,m} - \overline{v}_m \tag{21}$$

avec la tension moyenne instantanée

$$\overline{v}_m = \frac{1}{I} \sum_{j=1}^{I} v_{j,m} \tag{22}$$

est appelé "tension relative" dans le cadre de cette divulgation. La tension relative est nulle dans le cas d'un seul compteur rattaché au transformateur (i.e. $I$=1). La détection de NCE implique donc un réseau basse tension avec 2 compteurs et plus. En combinant les équations 20, 21 et 22, l'estimation de la tension relative instantanée au compteur $i$ est donnée par:

$$\Delta v'_{i,m} = V_{0m} - \sum_j \left(H_{i,j} - Z_0\right) \cdot c_{j,m} - \frac{1}{I}\sum_{n=1}^{I}\left(V_{0m} - \sum_j \left(H_{i,j} - Z_0\right) \cdot c_{j,m}\right) \tag{23}$$

qui donne finalement après quelques manipulations:

$$\Delta v'_{i,m} = -\sum_j \left(H_{i,j} - \frac{1}{I}\sum_{n=1}^{I} H_{i,j}\right) \cdot c_{j,m} = -\sum_j \Omega_{i,j} \cdot c_{j,m} \tag{24}$$

où

$$\Omega_{i,j} = H_{i,j} - \frac{1}{I}\sum_{j=1}^{I} H_{i,j} \quad . \tag{25}$$

L'introduction de la tension relative (équation 21) permet d'éliminer deux inconnues, soit la résistance commune $Z_0$ 15 et la tension $V_{0m}$ au noeud de référence. Si voulu, l'introduction de la tension relative peut être effectuée avant l'étape de l'estimation de la fonction de transfert (équation. 13a), donnant le même résultat.

L'équation 25 définit la "matrice ohmique relative" $\Omega_{i,j}$. Le qualificatif "relative" est attribué au fait que cette matrice multipliée par les courants donne les tensions relatives et tout comme la somme des tensions relatives est nulle, la somme des termes matriciels selon une rangée (indice $j$) est nulle.

En référence à la Figure 7, il est illustré un exemple de matrice ohmique relative. Les termes sur la diagonale sont positifs alors que les termes hors-diagonale sont en majeure partie négatifs. Sur une échelle couleur, les valeurs négatives peuvent être mises e.g. en rouge. Le compte de compteur commence à zéro pour la numérotation des compteurs pour chaque axe. En comparaison de la matrice ohmique donnée à l'équation 7, la matrice ohmique relative donnée à l'équation 25 n'est pas symétrique en raison des termes soustraits dans l'équation 25 qui ne peuvent être égaux s'il y a au moins un compteur qui a un rattachement différent des autres compteurs. Dans la présente divulgation, l'utilisation du terme "matrice ohmique" englobe la matrice ohmique généralisée Z, la matrice de fonction de transfert **H** et la matrice ohmique relative $\Omega$.

Avant de comparer les chutes de tension modélisées avec celles mesurées afin de détecter les NCE, les écarts systématiques de mesure de tension relatives par rapport à la tension moyenne déterminée à partir de l'ensemble ou un sous-ensemble de compteurs sont déterminés et minimisés. Une méthode d'estimation des coefficients d'étalonnage $\alpha_i$ pouvant être utilisée pour corriger la sensibilité des mesures de tension des compteurs est décrite dans la demande PCT/CA2017/050448 (Léonard et al.).

Sur une longue période de temps, des compteurs d'un même lot d'une même marque de manufacturier présenteront des écarts de facteurs d'étalonnage en fonction de la température accentués par le fait que certains des compteurs sont situés à l'extérieur alors que d'autres sont dans un bâtiment chauffé ou partiellement chauffé. Calculer et faire évoluer les valeurs des coefficients en fonction de la température apporte davantage de précision au prix d'une implémentation plus complexe. Il est souhaitable d'arrimer la méthode de calcul des coefficients d'étalonnage avec celle de la matrice de fonction de transfert en ce qui concerne le partitionnement ("bin") de la modélisation en fonction de la température.

Pour corriger la mesure de tension d'un compteur, un coefficient d'étalonnage $\alpha_i$ est inséré dans les équations 21-22, donnant respectivement la valeur de la tension relative

$$\Delta vv_{i,m} = \left(1 + \alpha_i\right) \cdot v_{i,m} - \overline{vv}_m \tag{26}$$

et la valeur de tension moyenne instantanée

$$\overline{vv}_m = \frac{1}{I}\sum_{j=1}^{I}\left(1 + \alpha_i\right)v_{j,m} \tag{27}$$

avec $\alpha_i$ un coefficient d'étalonnage tel qu'en absence d'anomalie $|\alpha_i| \le 0.002$ pour un compteur de type Classe 2 (0.2%), la somme des coefficients $\alpha_i$ étant nulle.

L'écart de tension observée entre la tension relative déterminée à partir de la mesure corrigée (éq. 26) et l'estimation de la tension relative (équation 21)

$$\Delta\Delta v_{i,m} = \Delta v v_{i,m} - \Delta v'_{i,m} \qquad (28)$$

donne un premier aperçu des possibilités de NCE. Un écart négatif de $\Delta\Delta v_{i,m}$ qui se démarque signifie la présence probable d'une NCE, la chute de tension mesurée étant plus grande que la chute de tension estimée. L'appellation double delta s'explique par une différence entre deux tensions qui sont elles-mêmes des différences par rapport à une tension moyenne instantanée. Le signal correspondant à la NCE tel qu'observé par le calcul de la divergence de tension $\Delta\Delta v_{i,m}$ est présent pour toutes les mesures de tension, est plus important en amplitude là où il y a une NCE au compteur d'un client ou proche de ce compteur, décroît en amont (vers le transformateur) à partir de la NCE, et est constant en aval du point de raccord de la NCE.

Dans cette divergence de tension, l'inconnue du branchement de dérivation répartissant la résistance $h_l$ entre $h_{l1}$ et $h_{l2}$ (comme montré à la Figure 1) n'est pas considérée. La divergence de tension est légèrement sous-estimée d'un rapport $h_{l2}/H_{l,l}$ là où il y a une dérivation 102 telle qu'illustrée à la Figure 1. De cette divergence de tension est calculé le courant correspondant

$$s_{i,m} = -\sum_j \left[\Omega_{i,j}\right]^{-1} \cdot \Delta\Delta v_{j,m} = -\sum_j \left[\Omega_{i,j}\right]^{-1} \cdot \left((1+\alpha_i) \cdot v_{i,m} - \overline{vv}_m - \sum_j \Omega_{i,j} \cdot c_{j,m}\right) \qquad (29)$$

qui n'a pas été mesuré par le compteur $i$ où $()^{-1}$ est un opérateur pseudo-inverse matriciel. La matrice $[\Omega_{i,j}]^{-1}$ constitue une transformée inverse, soit une transformée qui a pour input les écarts de chutes de tension relative instantanée des compteurs et comme output les courants non-mesurés correspondants. La matrice ohmique relative obtenue des mesures sur le réseau n'est pas usuellement inversable et seule un pseudo-inverse permet de s'approcher d'une solution plausible. Lorsque plusieurs compteurs sont très rapprochés, tel que dans un immeuble locatif où les compteurs sont rattachés à un même distributeur, les rangées de ces compteurs sont similaires dans la matrice faisant en sorte que la matrice ne peut être inversée. Ces compteurs peuvent alors être regroupés en un seul compteur représentatif (moyenne de tensions et somme des courants) et les compteurs ainsi regroupés sont remplacés par le compteur représentatif afin de permettre une inversion de la matrice ohmique relative. Lorsqu'il est impossible d'inverser la matrice ou pour toute autre raison, l'estimation du courant de non-conformité

$$s_{i,m} = k_{\Omega,i} \cdot \frac{\Delta\Delta v_{i,m}}{H_{i,i}}, \qquad (30)$$

peut être utilisée, bien que cela donne un résultat moins précis, avec le facteur de correction $k_{\Omega,i} \approx 1$. Dans le cadre de la présente divulgation, cette méthode est appelée "inverse diagonale". Le facteur $k_{\Omega,l} \approx \dfrac{H_{l,l}}{H_{l,l} - h_{l2}}$ peut être laissé à 1.0 ou, pour un résultat plus précis, ajusté de façon manuelle ou automatique, le critère d'optimisation étant une réduction maximale du résidu de tension RMS après modélisation des chutes de tensions attribuables aux courants mesurés additionnés des estimations des courants non mesurés, soit la minimisation de $STDV^2_{\Delta\Delta|s}$ présentée plus loin à l'équation 47. Le facteur $k_{\Omega,i}$ optimal n'est pas nécessairement plus grand que l'unité car il ne dépend pas uniquement de la répartition de la résistance $h_l$ entre $h_{l1}$ et $h_{l2}$. Entre autres, il corrige aussi les artefacts statistiques qui biaisent les estimations des termes de la matrice de fonction de transfert.

En référençant le réseau de résistances à une autre tension, un autre modèle matriciel équivalent à celui exposé ci-dessus peut être obtenu. Par exemple, une autre solution est d'écrire le modèle tel que

$$\mathbf{H} \cdot \begin{bmatrix} c_{1,m} \\ c_{2,m} \\ \vdots \\ c_{i,m} \\ \vdots \\ c_{I,m} \end{bmatrix} = \begin{bmatrix} V_{Sm} - v_{1,m} \\ V_{Sm} - v_{2,m} \\ \vdots \\ V_{Sm} - v_{i,m} \\ \vdots \\ V_{Sm} - v_{I,m} \end{bmatrix} \tag{31}$$

où $V_{Sm}$ est la tension d'un noeud de référence associé à la source génératrice de puissance du réseau électrique, à l'extrémité de la ligne en amont du transformateur, rapportée en basse tension selon le rapport de transformation. Tout comme $V_{0m}$, cette valeur est inconnue. En remplaçant la relation 20 par

$$v'_{i,m} = V_{Sm} - \sum_j H_{i,j} \cdot c_{j,m} \tag{32}$$

comme valeur estimée de tension au compteur $i$, et en choisissant les relations 21 et 22 pour définir la tension relative, l'expression

$$\Delta v'_{i,m} = V_{Sm} - \sum_j H_{i,j} \cdot c_{j,m} - \frac{1}{I} \sum_{n=1}^{I} \left( V_{Sm} - \sum_j H_{i,j} \cdot c_{j,m} \right) \tag{33a}$$

est obtenue en remplacement de la relation 23, donnant une matrice ohmique relative $\Omega_{i,j}$ identique à celle obtenue à la relation 25. Les tensions de référence $V_{0m}$ et $V_{Sm}$ de ces deux modèles sont liées par la relation

$$V_{Sm} = V_{0m} + Z_0 \cdot \sum_j c_{j,m} \tag{33b}$$

avec

$$Z_0 = -\frac{\sum_{j=1}^{I} \sum_{m=1}^{M} \partial V_{0m} \cdot \partial c_{j,m}}{\sum_{j=1}^{I} \sum_{m=1}^{M} \partial c_{j,m}^2} \tag{33c}$$

comme estimation suggérée pour la valeur de résistance commune.

Les écarts de tension relative peuvent être considérés non pas à chaque compteur mais par rapport à une tension de référence $V_{0m}$, $V_{Sm}$ ou autre estimée selon un compteur $i$. Par exemple, pour le second modèle, l'écart de tension relative instantanée

$$\Delta V_{Si,m} = \overline{V}_{Sm} - \left( v_{i,m} + \sum_{j=1}^{I} H_{i,j} \cdot c_{i,m} \right). \tag{34a}$$

est considéré avec

$$\overline{V}_{Sm} = \frac{1}{I} \sum_{i=1}^{I} \left( v_{i,m} + \sum_{j=1}^{I} H_{i,j} \cdot c_{i,m} \right) \tag{34b}$$

pour des développements similaires à ceux présentés pour les deux modèles précédents, qui aboutissent aussi à une matrice ohmique relative $\Omega_{i,j}$ telle celle obtenue à la relation 25. En fait, il existe une pluralité de modèles en fonction de la position de la référence de tension (i.e. noeud de référence utilisé). Ce qui est commun aux modèles est qu'ils correspondent à une matrice de résistances avec une tension référée à un noeud de référence disposé sur le réseau et qu'ils peuvent être exploités en utilisant une tension relative instantanée définie comme une différence de tension entre celle déterminée selon un compteur et celle déterminée selon l'ensemble ou un sous-ensemble des compteurs.

Si un courant estimée de non-conformité apparaît significatif pour le compteur *l* (comme montré à la Figure 4), il s'agit d'ajouter l'estimation (équation 29 ou 30) du courant de non-conformité au courant mesuré (équation la) et de recalculer **H,** selon l'équation 13a par exemple, afin d'obtenir des termes plus précis. La dérivée discrète de courant

$$\partial cs_{i,m} = cs_{i,m} - cs_{i,m-1} \tag{35}$$

tel que

$$cs_{i,m} = c_{i,m} + \delta(i-l) \cdot s_{i,m}, \ \delta(x) = \begin{cases} 0 & x \neq 0 \\ 1 & x = 0 \end{cases} \tag{36}$$

pourra alors être utilisée dans l'estimation de la fonction de transfert **H** proposée à l'équation 13a pour une NCE unique sur le réseau. Dans le cadre de la présente divulgation, cette fonction de transfert estimée en considérant une ou des estimations de NCE est appelée **Hs.** Dans la formulation donnée à l'équation 36, l'addition d'un seul courant non mesuré $S_{l,m}$ est allouée. Dans le cas où plus d'une NCE est suspectée sur le même réseau basse tension, l'équation 35 pourra inclure plus d'une estimation de courant de NCE.

L'erreur d'estimation d'un coefficient d'étalonnage $\alpha_i$ se traduit par un biais constant dans le courant de subtilisation déterminé avec l'équation 29. Par exemple, si ce coefficient est estimé à partir de groupes de mesures où le courant non mesuré est constant pour un client, le coefficient comportera une erreur d'estimation qui corrigera la chute de tension entraînée par ce courant non mesuré. Un courant négatif apparaîtra alors au moment où il n'y a plus de courant non mesuré. La variation du courant non mesuré déterminé avec l'équation 29 est exacte à une erreur additive constante près qui ne peut être évitée.

La méthode de calcul donnée à l'équation 29 ne peut être appliquée directement dans le cas d'une subtilisation par contournement. Si les valeurs des termes de la matrice de fonction de transfert ne sont pas ou peu affectées par une dérivation, par contre, ces termes sont modifiés significativement dans le cas d'un contournement. Typiquement, l'auto-terme du compteur contrevenant augmente dans le même rapport que celui du courant subtilisé sur le courant total. Si un autre compteur est situé proche du compteur contrevenant, alors l'équation 29 appliquée à ce compteur voisin donne un aperçu du courant subtilisé par le compteur contrevenant. Pour reconnaître un contournement, il suffit de constater que le courant subtilisé déterminé par l'équation 29 pour le compteur *i* correspond à un facteur multiplicatif près $k_l$ au courant mesuré par le compteur contrevenant *l*. Le facteur de contournement peut s'estimer de différentes façons. Par exemple, lorsque le compteur voisin *i* permet d'estimer le courant subtilisé par le compteur *l* alors

$$s_{l,m} = s_{i,m} \tag{37}$$

tel que

$$k_l = s_{i,m} / c_{l,m} \tag{38}$$

sinon le facteur $k_l$ qui symétrise la rangée et la colonne correspondant au compteur contrevenant *l* peut être trouvé tel que

$$s_{l,m} = k_l \cdot c_{l,m} \tag{39}$$

avec

$$k_l = \frac{\sum_{j=1}^{I} H_{i,l} - H_{l,l}}{\sum_{i=1}^{I} H_{l,i} - H_{l,l}} \tag{40}$$

Que ce soit pour l'une ou l'autre des deux méthodes d'estimation du contournement, la matrice de fonction de transfert peut être soit ré-estimée (par ex. avec l'équation 13a) à partir des valeurs de courant corrigées (par éq. 37 ou 39) ou corrigée avec

$$Hs_{i,j} = \begin{cases} H_{i,j}/k_l & \text{pour } j = l \\ H_{i,j} & \text{pour } j \neq l \end{cases} \tag{41}$$

de sorte que pour un contournement, il y a ajout du courant de subtilisation et aussi réestimation ou correction de la matrice de fonction de transfert. L'augmentation de précision de modélisation apportée en introduisant la répartition de résistance $h_l$ entre $h_{l1}$ et $h_{l2}$ dans les développements des relations 37 à 41 est souvent mineure en comparaison de l'apport des autres sources d'erreurs. La correction de la fonction de transfert (équation 41) donne en pratique de bons résultats lorsque le contournement est constant dans le temps.

La modélisation de la subtilisation peut parfois être plus complexe que celles présentés aux équations 34a, 34b et 35. Par exemple, dans le cas d'un système biénergie qui, pour une température moindre que -12°C, déconnecte les éléments électriques pour activer le chauffage par énergie fossile, une dérivation alternée peut être adjointe au système biénergie en commutant des éléments électriques en amont du compteur plutôt que déconnecter ceux-ci. La subtilisation est alors discontinue. Dans d'autres cas, les deux types de subtilisation, dérivation (équation 30) et contournement (équation 39) sont simultanément opérés et varient en proportion dans le temps. Si la détection de la présence de subtilisation est usuellement aisée, il se peut que sa quantification exige un effort de modélisation peu rentable ou irréaliste.

En référence à la Figure 3, l'identification d'un défaut de raccordement ou d'un point chaud dans une connexion d'un compteur à l'embase est simple. L'écart de tension (équation 28) n'est significatif que pour le candidat où sied le défaut. Les termes de la rangée correspondant au compteur où sied le défaut varieront temporellement avec les fluctuations du défaut. Un défaut de raccordement ou un point chaud étant un phénomène complexe et d'une évolution difficilement prévisible, sa modélisation est peu pertinente. Cependant, pour un intervalle temporel où le défaut apparaît stable, une correction instantanée de l'auto-terme de la matrice de fonction de transfert peut être apportée en y additionnant la résistance instantanée $F_{l,m}$ 113 correspondant à la chute de tension en fonction du temps tel que

$$H_{l,l,m} = H_{l,l} + F_{l,m} = H_{l,l} - \Delta\Delta v_{l,m}/c_{l,m} \quad . \tag{42}$$

Une fois **Hs** estimé, le calcul d'écart à la tension moyenne

$$\Delta vs'_{i,m} = -\sum_{j}\left( Hs_{i,j} - \frac{1}{I}\sum_{n=1}^{I} Hs_{n,j} \right) \cdot cs_{j,m} \tag{43}$$

(de l'équation 26) est effectué, et le calcul d'erreur de prédiction de l'écart de tension à la tension moyenne

$$\Delta\Delta vs_{i,m} = \Delta vv_{i,m} - \Delta vs'_{i,m} \tag{44}$$

(de l'équation 28) est effectué pour terminer avec le calcul des courants de subtilisation résiduels $S_{i,m}$ (équation 29 ou 30) considérant $\Delta\Delta vS_{i,m}$ au lieu de $\Delta\Delta v_{i,m}$. Si l'estimation du courant non mesuré est précise, alors les écarts de tension observés pour le compteur en faute diminuent et aussi les écarts pour d'autres compteurs impactés par le courant non mesuré. Un critère de succès peut donc être la minimisation des écarts entre le modèle et la mesure. Une estimation par approximations successives peut être appliquée avec l'apport de d'autres variables d'action (ex. valeur de $h_{l,1}$, effet de la température sur le réseau et sur la lecture de tension des compteurs) dans la modélisation.

Un processus pour minimiser l'écart quadratique

$$STDV_{\Delta\Delta}^2 = \frac{1}{I \cdot M} \sum_i \sum_m \Delta\Delta v_{i,m}^2 \quad, \tag{45}$$

calculé sur tous les enregistrements valides et les compteurs valides peut être avantageusement utilisé. Pour figurer une précision relative du modèle, cet écart quadratique peut être comparé avec

$$STDV_{\Delta}^2 = \frac{1}{I \cdot M} \sum_i \sum_m \Delta v_{i,m}^2 \quad, \tag{46}$$

soit l'écart quadratique total des tensions relatives. De même, pour estimer un gain de précision du modèle considérant l'ajout des courants de non-conformité, l'écart quadratique résiduel

$$STDV_{\Delta\Delta|s}^2 = \frac{1}{I \cdot M} \sum_i \sum_m \Delta\Delta vs_{i,m}^2 \quad, \tag{47}$$

peut être comparé avec $STDV_{\Delta\Delta}$. L'estimation des courants de non-conformité n'est pas valable lorsque $STDV_{\Delta\Delta s} > STDV_{\Delta\Delta}$, et pour un rapport $STDV_{\Delta\Delta s}/STDV_{\Delta\Delta}$ moindre que 0.5, l'estimation des courants de non-conformité est considéré vraisemblable. Un ratio

$$R = 100 \cdot STDV_{\Delta\Delta} / STDV_{\Delta} \quad (\%) \tag{48}$$

peut constituer un important indicateur de NCE possibles sur un réseau. Typiquement, un rapport de 10% ou moins est observé pour les réseaux bien modélisés par la méthode car sans anomalie majeure. Un rapport supérieur à 30% est un indicateur d'une NCE qui perturbe la prédiction du modèle ou d'un artefact statistique qui biaise la modélisation.

Par exemple, dans un cas de culture intensive de marihuana où de 75 A à plus de 150 A sont subtilisés selon un patron cyclique journalier et cyclique de récolte (60 à 90 jours), le rapport $R$ peut être proche de 100% d'erreur ou même supérieur à l'occasion.

Dans le cas d'une NCE correspondant à un contournement 106 (comme illustré à la Figure 2), l'erreur résiduelle $STDV_{\Delta\Delta|s}^2$ est peu ou pas modifiée par une variation du facteur de contournement $k_l$. Il peut être approprié de regarder, entre autres, du côté de la résistance apparente telle que décrite dans la demande PCT/CA2017/050448 (Léonard et al.) et de la dissymétrie de la matrice de fonction de transfert pour disposer d'un indicateur de la qualité de la modélisation du contournement.

L'introduction de plus d'un modèle de NCE pour un même réseau basse tension commande un ajustement simultané des paramètres des modèles (e.g. choix du modèle et facteur $k_{\Omega,i}$). Outre un ajustement manuel par essais et erreur, différentes méthodes d'optimisation peuvent être déployées. Parmi les critères d'optimisation, il y a, entre autres, la minimisation de l'erreur résiduelle $STDV_{\Delta\Delta|s}^2$ incluant la contribution de tous les modèles de NCE, il y a la symétrisation de matrice de la fonction de transfert, l'élimination de termes négatifs (résistance négatives) sur la diagonale (auto-termes) de la matrice de la fonction de transfert, la réduction de la dispersion de la matrice de la fonction de transfert et l'augmentation de la corrélation ainsi que de la cohérence d'un compteur qui a son courant corrigé par rapport à lui-même et les autres comme vu plus loin.

D'un point de vue outil diagnostic, une visualisation de la matrice de fonction de transfert peut être avantageuse par rapport à une visualisation de la matrice ohmique relative. En effet, dans le cas d'une modélisation réussie d'un réseau exempt de NCE avec tous les compteurs qui sont intelligents et rattachés au réseau modélisé, la matrice de fonction de transfert est très proche d'être symétrique par rapport à sa diagonale, tel qu'illustré à la Figure 6, ce qui n'est pas le cas de la matrice ohmique tel qu'illustré à la Figure 7. Au premier coup d'œil sur le rendu graphique de la matrice de fonction de transfert, la qualité de la modélisation peut être constatée et les compteurs affichant des anomalies de modélisation ou encore ceux qui possiblement correspondent à une NCE, tel un compteur non raccordé au réseau, peuvent être ciblés. Dans l'exemple donné à la Figure 6, le transformateur est situé au 3/8 du parcours de ligne alimentant d'un côté les compteurs 0, 1 et 2, et de l'autre côté les compteurs 3 à 7. Dans ce cas, les inter-termes plus foncés entre les deux groupes de compteurs opposés, soit les $H_{i;j}$ et $H_{j;i}$ pour lesquels $i \in [0,1,2]$ et $j \in [3,...,7]$, donne la valeur de résistance commune $Z_0$ (typiquement un peu moindre que 0.01 $\Omega$) au point de rattachement 23 des deux sections de ligne (comme illustré à la Figure 5B).

En référence à la Figure 6, dans la matrice de fonction de transfert, un axe de la matrice exprime l'influence qu'un courant d'un compteur donné a sur la tension des compteurs alors que l'autre axe exprime l'influence qu'a les courants des compteurs sur la tension d'un compteur donné. C'est pourquoi, sur les illustrations de matrice, les noms de compteur "parlant" et compteur "écoutant" ont été respectivement donnés aux axes.

La réalité statistique fait en sorte que des termes matriciels négatifs pour la fonction de transfert peuvent être observés, même s'il est inconcevable d'un point de vue physique qu'un conducteur ait une résistivité négative ou encore, que la tension augmente quand le courant augmente. Dans une implémentation graphique couleur, ces termes peuvent être mis e.g. en rouge pour les distinguer nettement des autres termes positifs. Des termes négatifs sont, par exemple, observés quand des compteurs alimentent le chauffage de zones attenantes tel qu'existant dans un immeuble locatif. Il y a un combat entre le chauffage commun et les chauffages des appartements lorsque les chauffages locatifs s'activent et que celui de la zone commune stoppe, le compteur alimentant le chauffage de la zone commune voyant alors une diminution de la tension avec la baisse de son courant transité. Des termes négatifs sont aussi observés pour de l'éclairage de ville ou d'espace locatif où un luminaire s'éteint le matin au début de l'heure de pointe (en croissance de courant) et s'allume à la fin de l'heure de pointe (en baisse de courant).

Un compteur rattaché à un autre transformateur que celui du réseau modélisé peut aussi expliquer la présence de termes négatifs pour les termes hors-diagonal où ce compteur est "parlant" ou "écoutant". La matrice de fonction de transfert telle qu'estimée à partir de l'équation 13a exprime une réalité statistique construite à partir d'un ensemble de mesures de courant qui ne sont pas décorrélées entre elles, ce qui fait que certaines inter-corrélations génèrent des valeurs loin de la réalité attendue pour un circuit électrique. Les termes matriciels approchent la réalité résistive du réseau pour des clients où des courants significatifs sont commutés aléatoirement. Les clients ayant une consommation selon un horaire journalier programmé ou qui partagent un processus commun (climatisation, chauffage ou éclairage) avec d'autres clients sont plus sujet à avoir des termes matriciels qui s'écartent de la réalité résistive du réseau.

Malgré les artefacts générés occasionnellement par une inter-corrélation des charges dans le temps, la comparaison de la résistance des inter-termes entre différents compteurs permet d'identifier un compteur qui n'est pas rattaché avec le réseau basse tension modélisé, les compteurs qui sont regroupés ou rapprochés et ceux qui sont isolés, un compteur défectueux, une subtilisation par contournement, un rattachement défectueux, et un point chaud dans une embase de connexion d'un compteur.

En référence la Figure 8, il est illustré un exemple de matrice de fonction de transfert obtenue pour 5 compteurs où le dernier compteur (le #4) n'est pas en réalité rattaché au même transformateur que les quatre autres compteurs. Il est constaté que si l'auto-terme $H_{4,4}$ a une valeur plus petite que les autres mais néanmoins plausible, les termes hors-diagonal associés à ce compteur sont proches d'être nuls car en mode "écoutant", le compteur #4 n'entend que lui-même et en mode "parlant", les autres compteurs ne l'entendent pas. Pour cet exemple, il y a des cycles de serres déterminés selon l'équation 29 pour une dérivation au premier compteur (#0). Cet exemple démontre aussi qu'une dérivation, tout comme la présence d'un courant non-mesuré (compteur électromécanique, rattachement sans compteur à montant forfaitaire, etc.) n'est pas mise en évidence par la matrice de fonction de transfert. C'est l'utilisation de cette matrice qui permet de mettre en évidence les courants non mesurés.

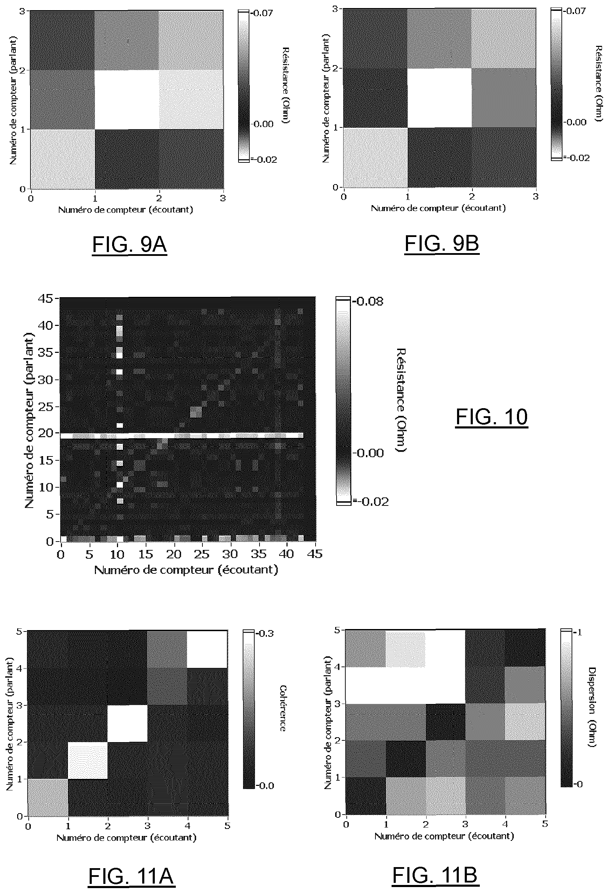

En référence à la Figure 9A, il est illustré un exemple de matrice de fonction de transfert obtenue pour 3 compteurs où une dissymétrie des termes hors-diagonal est observée pour le compteur #1. Si le courant mesuré de ce compteur est augmenté proportionnellement de 80%, la fonction de transfert illustrée à la Figure 9B est obtenue et apparaît davantage symétrique. Pour les termes où le compteur est "parlant", soit la rangée 1 de la matrice, un contournement diminue la valeur mesurée de courant sans affecter la mesure de tension. Pour tous les compteurs, les grandeurs résistives de la rangée correspondante sur la fonction de transfert sont augmentées selon le rapport de contournement "courant réel" / "courant mesuré".

En référence à la Figure 10, il est illustré un exemple de matrice de fonction de transfert obtenue pour 43 compteurs où il apparaît trois anomalies. La première anomalie, la plus visible, est une ligne horizontale coïncidant avec le compteur #19 et correspond à un artefact statistique. L'aberration statistique est expliquée par l'influence dominante d'une minuterie d'éclairage sur la dérivée en courant du compteur #19. Ce compteur est écarté du calcul des estimations des courants non mesurés. La seconde anomalie est une ligne discontinue à la verticale coïncidant avec le compteur #10 et expliquée par la présence d'un point chaud à la connexion supérieure du compteur confirmée par une inspection sur le terrain. Si la présence d'un point chaud n'influence pas la mesure de courant du compteur, elle biaise par contre sa mesure de tension. En mode "écoute", le compteur #10 perçoit les chutes de tension générées par les courants des autres compteurs soustraites de la tension plus ou moins aléatoire présente aux bornes du point chaud. Les chutes de tensions des autres compteurs apparaissent donc peu cohérentes avec les courants transités, augmentant ainsi l'aléa de la valeur résistive du terme correspondant dans la fonction de transfert. La troisième anomalie est une ligne discontinue à l'horizontale coïncidant avec le compteur #0. Ce compteur ne transitant presque pas de courant, les termes où il est "parlant" ont des estimations erronées.

La matrice de fonction de transfert contient l'information relative à la répartition des chutes de tension sur le réseau en fonction des courants transités. Cette information constitue un indicateur utile pour réaliser un diagnostic de NCE. Les aléas agitant la fonction de transfert constituent des indicateurs complémentaires. Différents moyens d'évaluation des aléas agitant la fonction de transfert peuvent être utilisés, comme le calcul de dispersion, l'inter-corrélation et la cohérence.

$$\sigma_{i,j} = \frac{1}{H_{i,j}^{(1)}} \cdot \sqrt{\frac{1}{M-1} \cdot \frac{\sum_{m=1}^{M}\left(\partial c_{i,m} \cdot H_{i,j} - \partial v_{j,m}\right)^2}{\sum_{m=1}^{M} \partial c_{i,m}^2}} \qquad (49)$$

fournit une estimation de la dispersion relative sur la fonction de transfert $H_{i,j}$. Typiquement, une dispersion relative de moins de un dixième correspond à une bonne estimation (10% de dispersion). Dans un premier aspect, le calcul de dispersion relative permet d'apprécier la précision de l'estimation de chacun des termes de la matrice de fonction de transfert et d'apprécier la qualité de la modélisation. Dans un second aspect, par ordre de sensibilité de + à ++++, la dispersion relative entre différents compteurs est influencée par: un compteur contributif dans la fonction de transfert et qui n'est pas rattaché avec le réseau basse tension modélisé (++++) (erreur d'appariement compteur-transformateur); un courant non mesuré par les compteurs pris en compte dans la fonction de transfert (compteur électromécanique, rattachement forfaitaire ou dérivation) (++); une NCE s'apparentant à un contournement (+); une subtilisation avec commutation régulière du moyen de subtilisation (++++); et un défaut de raccordement ou un point chaud (+++).

Les compteurs qui transitent de faibles courants auront des valeurs importantes de dispersion relative inscrites dans leur rangée en mode "parlant" alors qu'en mode "écoute", selon la colonne correspondante, ils présenteront une faible dispersion relative. Usuellement, la dispersion est moindre pour les termes de la diagonale car les compteurs y sont à la fois "parlant" et "écoutant" avec la résistance de raccordement 9 (illustrée à la Figure 4) comme amplification de la relation delta-courant à delta-tension. À l'exception de son terme diagonal, un compteur non rattaché au réseau présente une dispersion relative importante pour la rangée et la colonne puisqu'il n'a pas significativement de relation de cause à effet avec les autres compteurs. La seule inter-corrélation qui subsiste entre un compteur extérieur au réseau est celle avec le profil moyen de la variation cyclique de charge journalière et cette inter-corrélation peut donner des valeurs de résistance négatives comme positives, selon les artefacts statistiques qui prédominent.

Un autre moyen de mesurer la qualité de la modélisation, de déceler et caractériser des NCE est par un calcul des inter-corrélations entre les variations de tension et les variations de courant. La corrélation entre courant et tension

$$\eta_{i,j} = \frac{\left|\sum_{m=1}^{M} \partial c_{i,m} \cdot \partial \widehat{v}_{j,m}\right|}{\sqrt{\sum_{m=1}^{M} \partial c_{i,m}^2 \cdot \sum_{m=1}^{M} \partial \widehat{v}_{j,m}^2}} \qquad (50)$$

correspond à la formulation de Bravais-Pearson, en proposant que $\sum_{m=1}^{M} \partial \widehat{v}_{i,m} \cong 0$ et $\sum_{m=1}^{M} \partial c_{j,m} \cong 0$, pour laquelle une valeur absolue est ajoutée pour des motifs de convivialité pour un affichage graphique. Les consommateurs significatifs de courant auront une autocorrélation importante, soit approchante ou supérieure à 0.5 sur la diagonale de la matrice de corrélation générée avec l'équation 50. Les valeurs hors-diagonale de la matrice de corrélation sont usuellement bien inférieures à 0.5. Les compteurs rapprochés entre eux auront des termes commun hors-diagonale plus grands. La corrélation donne du poids à la vraisemblance d'un courant non mesuré. Quand l'ajout du courant non mesuré (équation 29) au calcul de corrélation fait augmenter la corrélation d'un compteur par rapport à lui-même et les autres, cela donne de la crédibilité à l'estimation de ce courant.

Dans une représentation multidimensionnelle, la corrélation peut être vue comme une mesure de la colinéarité vectorielle entre le vecteur courant et le vecteur tension. La magnitude relative des vecteurs n'est pas prise en compte.

Le calcul de cohérence

$$\gamma_{i,j} = \sqrt{\frac{\left(\sum_{m=1}^{M} \partial \widehat{v}_{i,m} \cdot \partial c_{j,m}\right)^2}{M \cdot \sum_{m=1}^{M} \left(\partial \widehat{v}_{i,m} \cdot \partial c_{j,m}\right)^2}} \tag{51}$$

donne une information un peu différente de la corrélation. En effet, en représentation multidimensionnelle, la cohérence équivaut au rapport de la longueur du vecteur résultant de la somme des vecteurs contributifs sur la somme des longueurs de ces vecteurs. Un vecteur contributif correspond ici au produit terme à terme du vecteur courant et du vecteur tension. Contrairement à la corrélation, les magnitudes sont contributives, ce qui fait de la cohérence souvent un meilleur outil de caractérisation de NCE.

La Figure 11A illustre un exemple de matrice de cohérence. En ton noir et blanc, la matrice de corrélation apparaît similaire alors qu'avec un rendu en couleur (non illustré), la différence peut être observée. Usuellement, pour un rendu en couleur, le résultat obtenu avec la matrice de cohérence est préféré. Dans le cas présenté à la Figure 11A, le compteur #3 est vu comme une NCE probable qui présente une faible auto-cohérence et presque pas d'inter-cohérence. La dispersion relative de la fonction de transfert du même cas illustré à la Figure 11B montre que la dispersion de l'auto-terme (terme diagonal) du compteur #3 est la plus élevée et que les termes hors-diagonal de ce compteur en mode "parlant" sont bien plus élevés que ceux en mode "écoute", imprégnant une dissymétrie marquée dans la matrice, confirmant la possibilité d'une NCE.

Différentes méthodes d'estimation de la matrice de fonction de transfert peuvent être mises en œuvre et certaines de celles-ci visent une paramétrisation de la fonction de transfert selon la température et la charge sur le réseau. Peu d'amélioration est obtenue en introduisant la variation de la résistance des conducteurs avec la température

$$H_{i,j} = \frac{\sum_{m=1}^{M} \left(1 + \beta \cdot \left(T_m - T_r\right)\right)^{-1} \cdot \partial v_{i,m} \cdot \partial c_{j,m}}{\sum_{m=1}^{M} \partial c_{j,m}^2} \quad \text{et} \tag{52}$$

$$\Delta v'_{i,m} = -\left(1 + \beta \cdot \left(T_m - T_r\right)\right) \cdot \sum_j \left(H_{i,j} - \frac{1}{I} \sum_{n=1}^{I} H_{n,j}\right) \cdot c_{j,m} \tag{53}$$

où $\beta$ est le coefficient de variation de la résistance avec la température et $T_r$ est la température de référence (usuellement 0°C). Par contre, un binage de la fonction de transfert et, par extension, de la matrice ohmique relative en fonction de la température améliore significativement la modélisation.

Dans la demande PCT/CA2017/050448 (Léonard et al.), une des méthodes proposées construit une cohorte d'échantillons qui correspondent à un rapport de charges qui dépasse un seuil donné, ce rapport étant, par exemple, la charge d'un compteur donné sur la charge correspondant à la somme des autres compteurs. Le calcul de la fonction de transfert avec l'équation 13a pour les termes où le compteur sélectionné est "parlant" peut avantageusement être réalisé à partir des échantillons d'une telle cohorte où le compteur "parlant" parle fort. Cette méthode permet de cumuler dans les sommations de l'équation 13a des informations moins bruitées. Par exemple, dans le cas de deux compteurs dominant la charge et transitant des courants importants, quand un se tait, l'impact de la variation de charge de l'autre est écoutée et vice-versa. Évidemment, les compteurs ne mesurant pas de courant significatif généreront une cohorte de population réduite, sinon nulle. Le terme matriciel correspondant est alors mis à la valeur plancher des autres termes, soit proche de la valeur $Z_0$.

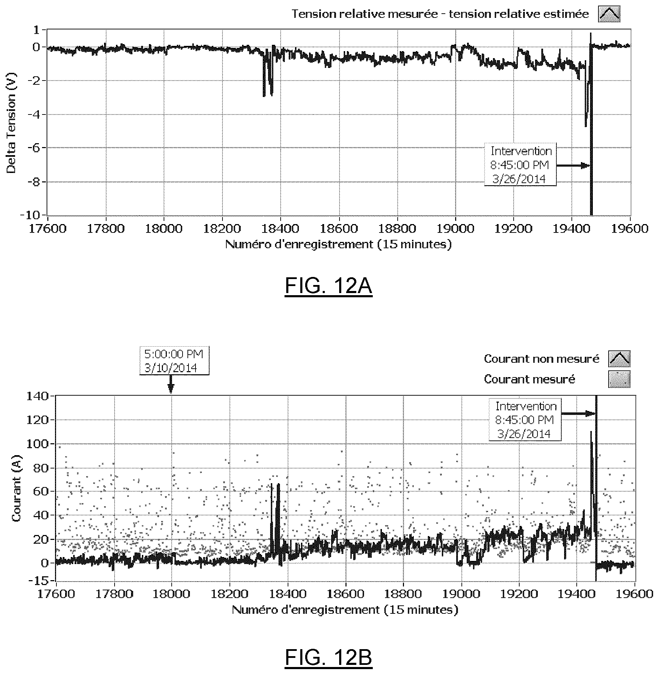

En référence à la Figure 12A, il est illustré un cas de point chaud sur un compteur observé à partir d'une anomalie de $\Delta\Delta v_{i,m}$, soit la différence entre la tension relative mesurée et la tension relative prédite. La présence d'un point chaud vient augmenter la chute de tension perçue au compteur qui cause une anomalie progressive d'une durée de plus de 15 jours jusqu'à une intervention sur le compteur. Les chutes de tension estimées correspondent à des mesures moyennées sur 15 minutes. Les chutes de tension instantanée (fraction de seconde) perçues par le client peuvent être beaucoup plus importantes que la crête observée proche de 5 V un peu avant l'intervention corrective. La Figure 12B affiche le courant mesuré (nuage de points) et l'estimation du courant non mesuré (courbe continue) pour ce même exemple. Selon le modèle estimé, la chute de tension de près de 5 V correspond à un courant non mesuré de 110 A selon un patron incompatible à une subtilisation d'énergie. La différence entre la tension relative mesurée et la tension relative prédite offre plus de sensibilité qu'une simple observation graphique de la fonction de transfert et permet une qualification et une quantification du phénomène de point chaud ou de défaut de raccordement. Un simple calcul du produit de l'écart de chute de tension $\Delta\Delta v_{i,m}$ par le courant mesuré détermine la source chaleur en Watts correspondant à l'anomalie trouvée. Typiquement, un seuil de 250 W est fixé pour déterminer s'il y a risque d'incendie et le dépassement de ce seuil initie une décision d'interrompe le service qui est transmise au compteur. Dans le cas d'un point chaud de type résistif, la chute de tension apparaît proportionnelle au courant, parfois avec un délai d'origine d'échauffement thermique, faisant en sorte que ce type de point chaud pourrait être confondu avec un contournement.

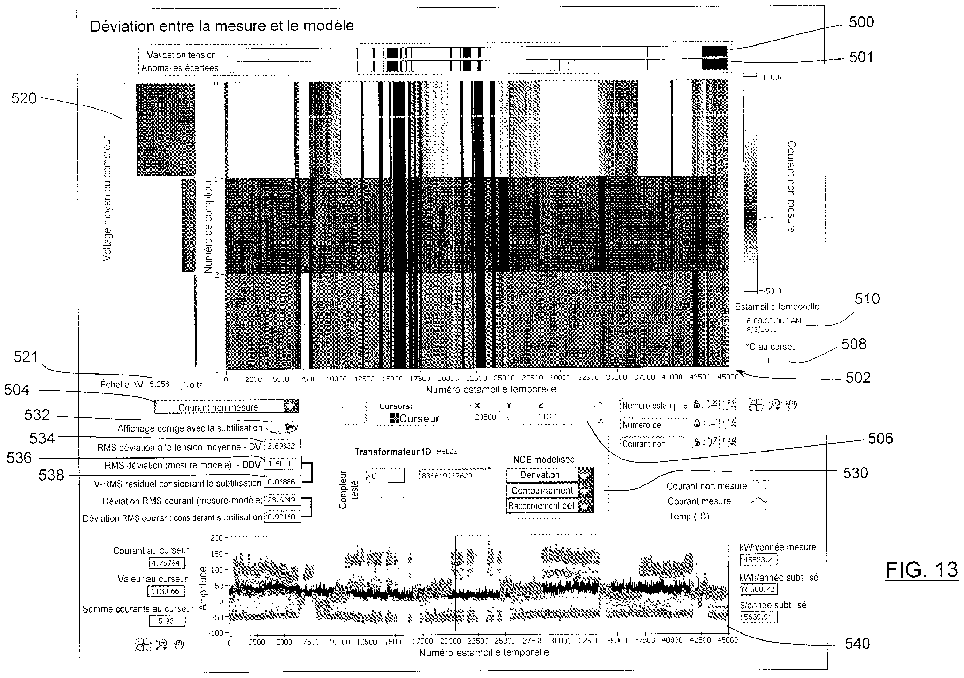

En référence à la Figure 13, il est illustré un exemple d'interface utilisateur graphique (IUG) implémenté dans un système selon l'invention, ayant des composants interactifs de commande et de contrôle de séquences et paramètres de la méthode. L'IUG permet entre autres de visualiser diverses informations générées et produites par la méthode, et d'interagir avec des fonctions détection de NCE implémentées selon la méthode, ainsi que de régler ou ajuster des valeurs de seuil pouvant déclencher des procédures de recalculs des matrices ohmiques et autres selon de nouveaux paramètres ou des alertes de détection de NCE potentielles détectées. Dans l'exemple d'IUG illustré, il est traité un cas de subtilisation massive d'électricité pour une serre de production de marihuana. Dans l'IUG, en débutant par le haut, deux barres horizontales 500, 501 présentent un état de validité des groupes de mesures. La barre 500 est obtenue avec la détection des pertes de tension et des surtensions. La barre 501 présente un résultat où s'ajoutent les anomalies mineures détectées après un premier calcul de matrice ohmique. Différentes grandeurs mesurées ou prédites peuvent être affichées sur le principal affichage graphique 502 en fonction du temps et d'identifiants compteurs. L'échelle temporelle peut être en heure, en jours, en numéro de groupe de mesures (comme affiché sur le graphe) ou autre unité temporelle. Les identifiants compteurs peuvent être des numéros d'ordre des compteurs, des numéros anonymes ou d'autres identifiants. Le choix de la grandeur affichée peut se faire à l'aide d'un menu déroulant 504. Les grandeurs utiles qui peuvent être affichées incluent la tension mesurée, la différence entre la tension mesurée et la tension moyenne, le courant mesuré, le delta chute de tension $\Delta\Delta v_{j,m}$ et le courant non mesuré. Un curseur avec une boîte de configuration et d'affichage 506 permet de lire les valeurs graphiques en affichant simultanément la température correspondante 508 et l'estampille temporelle 510. Un graphe thermomètre 520 affiche la tension moyenne de chaque compteur permettant de comparer la tension moyenne avec le courant mesuré et le courant non mesuré. Pour le graphe 520, l'intervalle du débattement du thermomètre est donné en-dessous 521, soit 5.258 V dans l'exemple. Dans l'encadré 530 où s'affiche l'identifiant du transformateur du réseau scruté, l'utilisateur peut manuellement configurer des modèles de NCE en sélectionnant le numéro de compteur, le type de NCE et autres paramètres (non visible pour la sélection "dérivation"). Au moyen d'un commutateur 532, l'utilisateur peut visualiser le graphe 502 pour lequel les écarts de chute de tension $\Delta\Delta v_{j,m}$ et les courants non mesurés sont modifiés en prenant en compte la contribution des NCE suspectés. Pour juger de la qualité de la modélisation, la déviation quadratique à la tension moyenne $STDV_\Delta^2$ 534 est affichée et comparée avec la déviation résiduelle après modélisation du réseau $STDV_{\Delta\Delta}^2$ 536 et la déviation résiduelle après modélisation du réseau et des NCE $STDV_{\Delta\Delta|s}^2$ 538. Un affichage graphique 540 situé en bas de l'IUG peut présenter le tracé du compteur correspondant au curseur dans le graphe principal 502, ou les mesures relatives à l'un des compteurs qui a une NCE modélisée, le tout superposé avec les tracés de température et de courant du compteur sélectionné. La position temporelle du curseur du graphe inférieur 540 suit la position du curseur du graphe supérieur 502. À gauche du graphe inférieur 540 se retrouvent les valeurs de courant, de somme du courant et la valeur au curseur pour la position du curseur. À droite se retrouvent les énergies annuelles mesurées et subtilisés en KWh et en unité monétaire.

Une sélection de la ligne et du transformateur, de même que les paramètres de lecture, soit le début et la fin des groupes de mesures à traiter, les paramètres de validation, telles la tension minimale et la tension maximale, peuvent être réalisés sur une autre fenêtre d'IUG (non illustrée). Une visualisation des matrices, i.e. fonction de transfert, dispersion, corrélation et cohérence comme illustrées dans les Figures 6, 7, 8, 9A, 9B, 10, 11A et 11B, peut aussi être générée dans une autre fenêtre d'IUG (non illustrée). Une forme condensée de l'IUG et des différentes fenêtres peut être réalisée pour un affichage sur un téléphone cellulaire ou une tablette (non illustrés), et peut fournir un mode "expert" de visualisation présenté à l'utilisateur suite à une détection d'une NCE par la méthode selon l'invention. L'IUG peut être simplifiée pour fournir un mode "normal" adapté aux besoins d'un utilisateur non expert sur le terrain et qui permet de savoir le type de NCE décelé, où se situe la NCE sur le réseau, et si disponible un indice de vraisemblance des résultats.

Concernant le cas de subtilisation présenté à la Figure 13, la tension moyenne du compteur fautif est plus de 4 V plus basse que celles des autres compteurs. Un calcul à partir de cette chute de tension et de la résistance correspondant à l'auto-terme de la matrice de la fonction de transfert (non illustrée pour ce cas) soit 0.055 Ω, donne une moyenne de 4/0.055 = 72 A de courant total, soit le courant mesuré plus celui de la subtilisation. Le graphe 540 de l'IUG affiche une subtilisation atteignant 150 A mais négative de plus de 50 A, donnant une valeur crête-à-crête avoisinant 200 A. La subtilisation introduit un biais dans la méthode d'étalonnage de la tension du compteur #3 qui déplace d'une valeur constante l'estimation du courant de subtilisation. Différents moyens peuvent être mis en œuvre pour renormaliser la courbe du courant de subtilisation pour une estimation plus précise des kW subtilisés. Une méthode consistant à prendre la valeur négative la plus basse comme valeur plancher et soustraire cette valeur négative de l'estimée (i.e. soustraire une valeur négative revient à additionner la grandeur positive correspondante) n'est pas préconisée car elle conduit à une surestimation des courants de subtilisation en ajoutant la valeur crête de l'aléa, à laquelle contribue le bruit de mesure, à la grandeur du courant estimé pour la subtilisation. Une méthode visuelle consiste à estimer une position du milieu de la trace de plancher et de prendre la grandeur correspondante comme valeur à additionner pour la renormalisation. Sur la Figure 13, cette grandeur est d'environ 50 A. La méthode visuelle peut être automatisée en réalisant un histogramme pour la portion des valeurs les plus négatives afin de retrouver un premier sommet d'histogramme à partir de moins l'infini. Le premier sommet d'histogramme correspond alors à la grandeur de la correction à appliquer pour la renormalisation. La recherche du sommet peut être limitée à un percentile maximum des données, soit typiquement 10%. En faisant la somme des KWh annuel mesurés et subtilisés, le cas illustré à la Figure 13 donne un courant équivalent de 78 A pour une tension de 245 V, ce qui donne proche du courant moyen estimé précédemment de 72 A à partir de la chute de tension moyenne. Dans cet exemple la déviation quadratique à la tension moyenne $STDV_\Delta^2$ 534 affichée est de 2.69 VRMS, la déviation résiduelle après modélisation du réseau $STDV_{\Delta\Delta}^2$ 536 est de 1.48 VRMS et la déviation résiduelle après modélisation du réseau et des NCE $STDV_{\Delta\Delta|s}^2$ 538 est de 0.048 VRMS, ce qui démontre une bonne modélisation. Pour des compteurs qui ont une spécification de $\pm 0.2\%$, soit $\pm 0.5$ V, l'IUG affiche, dans cet exemple, un écart RMS de modélisation dix fois moindre que la spécification malgré une situation de NCE majeure.

La détection d'anomalie et la caractérisation diagnostique des anomalies détectées peuvent faire appel à des dépassements de seuils pouvant être en bonne partie déterminés manuellement, d'où l'intérêt d'une IUG avec des fenêtres pouvant afficher les matrices de fonction de transfert, de dispersion, de corrélation et de cohérence. Les seuils pour une même fonction de détection peuvent être ajustés en fonction du nombre de compteurs et de la grandeur du réseau (en ville ou en campagne), la grandeur du réseau étant estimée à partir des valeurs résistives de la matrice de fonction de transfert. Parmi les seuils fixés pour les termes de la matrice de fonction de transfert, des seuils pour la valeur résistive maximale (1 Ohms) des auto-termes et la valeur résistive minimale (8 mOhm) pour les inter-termes (hors diagonal) peuvent être appropriés. Le dépassement d'un seuil pour la différence relative moyenne entre les inter-termes "parlant" et "écoutant" d'un compteur signale une dissymétrie possiblement reliée à une NCE de type point chaud ou contournement. Les dépassements de seuils ne sont considérés valides que pour les termes correspondant à des compteurs qui en mode "parlant" manipulent un courant minimal significatif selon un autre seuil basé sur la distribution des dérivées de courant. Parmi les seuils fixés pour les termes des matrices de dispersion, de corrélation et de cohérence, des seuils pour la valeur minimale des auto-termes et pour la valeur minimale des inter-termes (hors diagonal) peuvent être fixés. Encore ici, les dépassements des seuils ne sont considérés valides que pour les termes correspondant à des compteurs qui en mode "parlant" manipulent un courant minimal significatif pour être entendus par les autres compteurs. Concernant le calcul des écarts de tension entre la tension relative mesurée et celle estimée, un seuil peut être fixe ou s'ajuster en fonction de l'écart quadratique résiduelle $STDV_{\Delta\Delta|s}^2$ défini à l'équation 47 de sorte que la sensibilité s'accroît avec la précision de la modélisation. Selon les différents dépassements de seuils observés par le système, celui-ci peut identifier le type de NCE correspondant à partir d'un tableau diagnostique disponible dans la base de données 301 (illustrée à la Figure 15). Des seuils basés sur la reconnaissance de patrons particuliers de NCE sur les valeurs estimées et générées par le modèle matriciel ohmique avec la méthode selon l'invention peuvent aussi être ajoutés.

En additionnant les consommations de l'ensemble des compteurs reliés à un transformateur et en prenant la tension estimée de ligne (rapportée à une valeur moyenne selon le rapport de transformation)

$$V_{Lm} = \frac{1}{I} \sum_{i=1}^{I} \left( v_{i,m} + \sum_{j=1}^{I} H_{i,j} \cdot c_{i,m} \right) \tag{54}$$

une mesure de tension et une mesure de courant par transformateur sont obtenus. Un courant non mesuré $s_{i,m}$ peut être ajouté à $c_{i,m}$ dans l'équation 50 si le courant est connu avec suffisamment d'assurance. Il s'agit alors de remplacer les compteurs dans la méthode selon l'invention par des transformateurs ayant chacun une mesure de tension et une mesure de courant. De la sorte, il est possible de modéliser le réseau moyenne tension, déceler des NCE pour les transformateurs auxquels se rattache un seul compteur, déceler des NCE non détectées pour certains transformateurs et déceler d'autres NCE sur le réseau moyenne tension tel un transformateur non-autorisé réalisant une dérivation sur la ligne moyenne tension. Le rapport de transformation n'est pas nécessairement identique d'un transformateur à l'autre en raison, entre autres, des différents modèles (gabarit et marque de commerce) créant alors un biais ratiométrique entre les tensions des transformateurs. Or, les écarts d'étalonnage entre compteurs sont aussi de nature ratiométrique.

La méthode de correction des tensions proposée aux équations 26 et 27 vise alors aussi l'uniformisation des rapports de transformation présents sur la ligne scrutée. La méthode décrite dans la demande PCT/CA2017/050448 (Léonard et al.) peut alors être adaptée afin d'estimer les valeurs de coefficient d'étalonnage. La perte de charge en ligne moyenne tension étant plus réduite comparativement à la perte de charge en ligne basse-tension, cette réalisation de la méthode s'adresse surtout à des réseaux moyenne tension étendus sur un grand territoire.

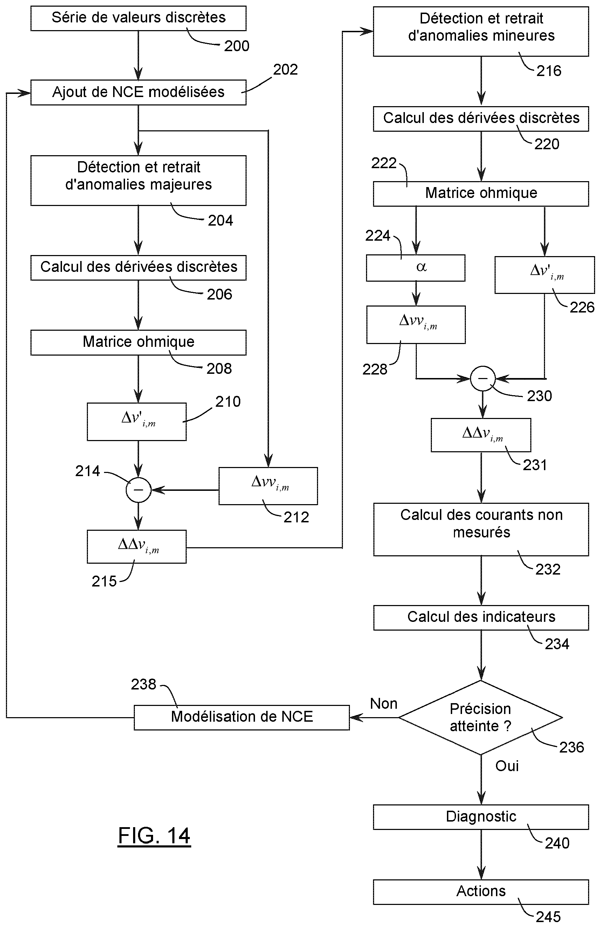

En référence à la Figure 14, il est illustré un organigramme d'étapes pour une réalisation possible de la méthode selon l'invention. La méthode peut débuter avec l'étape 200 consistant en une interrogation d'une base de données 301 (illustrée à la Figure 15) et des calculs afin de déterminer des valeurs discrètes de tension et de courant relatifs à un réseau basse tension regroupant un ensemble de compteurs intelligents possiblement rattachés à un même transformateur. La base de données 301 décrit des appariements transformateur-compteur utilisés dans l'interrogation afin de collecter des groupes de mesures communes aux compteurs rattachés à un transformateur ciblé. Un début et une fin des données traitées, donc un nombre de groupes de mesures, sont déterminés à cette étape. La méthode peut être appliquée successivement à des blocs de groupes de mesures contigus ou partiellement superposés, auquel cas s'ajoute un paramètre définissant un pas entre deux blocs traités, soit un nombre de groupes de mesures distançant chaque bloc à traiter. Sur plusieurs blocs contigus, il est normal d'avoir des compteurs qui changent d'appariement de transformateur. Les blocs peuvent alors être écartés si une population de groupes de mesures est inférieure à un seuil donné, ou tronqués en début ou en fin là où un changement d'appariement se produit de sorte que les groupes de mesures traitées le soient pour une même configuration de réseau basse tension. Dans une première itération, il n'y a pas d'ajout de courant correspondant aux NCE modélisées à l'étape 202. Un calcul de dérivées discrètes de tension et de courant est effectué à l'étape 206 après l'étape 204 de détection et retrait d'anomalies majeures découlant entres autres de pannes de courant, de surtensions et d'erreurs de synchronisation temporelle des données. L'étape 208 procède au calcul de la matrice ohmique générant la matrice de fonction de transfert et, si requis comme expliqué ci-dessus, la matrice de dispersion de la fonction de transfert, la matrice de cohérence, la matrice de corrélation, la matrice ohmique relative, et est suivi par l'étape 210 réalisant une estimation des chutes de tension $\Delta v'_{i,m}$. Des écarts à la tension relative $\Delta vv_{i,m}$ sont déterminés à l'étape 212 et les chutes de tension $\Delta v'_{i,m}$ sont soustraites de ces écarts à l'étape 214 afin d'obtenir l'écart sur la chute de tension $\Delta\Delta v_{i,m}$ entre le mesuré et le modélisé à l'étape 215. Cet écart est par la suite comparé, à l'étape 216, à un seuil, pour chaque compteur pris individuellement ou pour un signal regroupant les écarts des compteurs, de façon à détecter des anomalies mineures. Usuellement, les anomalies mineures détectées à l'étape 216 sont retirées pour la suite du traitement. Cependant, dans certaines circonstances où ces anomalies représentent une fraction importantes de la population des groupes de mesures, l'inverse peut être fait, c'est-à-dire que les données normales sont retirées et les données anormales sont conservées au cas où les données normales correspondraient à un état de subtilisation et les données anormales à un état de non subtilisation. Le calcul des dérivées discrètes de tension et de courant, le calcul de la matrice ohmique et l'estimation des chutes de tension $\Delta v'_{i,m}$ sont repris aux étapes 220, 222 et 226 sur le nouvel ensemble des groupes de mesures déterminé à l'étape 216. Comparativement à l'étape 208 effectuée avant d'écarter les données correspondant aux anomalies mineures, l'étape 222 comporte préférentiellement une sous-étape additionnelle de correction de certains termes de la matrice de fonction de transfert par, entre autres, la symétrisation et l'usage de la méthode de recuit simulé ou "simulated annealing" afin de préciser la valeur de certains termes en minimisant l'erreur de la modélisation. L'étape 228 de calcul de la tension relative $\Delta vv_{i,m}$ s'effectue avec les tensions étalonnées à partir de facteurs d'étalonnage $\alpha$ déterminés par calcul à l'étape 224. Les chutes de tension $\Delta vv_{i,m}$ calculées à l'étape 228 sont soustraites à l'étape 230 des écarts $\Delta v'_{i,m}$ estimés à l'étape 226 afin d'obtenir l'écart sur la chute de tension $\Delta\Delta v_{i,m}$ à l'étape 231 qui est suivie par l'étape 232 du calcul des courants non mesurés et l'étape 234 du calcul des indicateurs de qualité de l'analyse telles les valeurs $STDV^2_\Delta$,    $STDV^2_{\Delta\Delta}$    et $STDV^2_{\Delta\Delta|s}$.

L'étape 236 décide si la précision de la modélisation est atteinte. En mode automatique, des indicateurs de qualité peuvent être comparés à un seuil pour déterminer si la précision ciblée est atteinte et cesser alors les itérations pour terminer l'exécution de la méthode et transmettre les résultats par exemple pour enregistrement dans une base de données, pour un traitement subséquent ou un affichage sur un écran. En mode manuel, l'utilisateur peut choisir de soumettre des modifications de modélisation des NCE par l'étape 238 qui entraîne une réitération des étapes de modélisation, ou d'arrêter les itérations. La modélisation d'une NCE est en fonction du type de NCE suspectée. Par exemple, pour un contournement, le courant mesuré est multiplié par un facteur de subtilisation suspecté. S'il est observé que le courant de contournement représente 30 % du courant mesuré par le compteur, le courant mesuré à l'étape 202 est multiplié par 1.3 pour le compteur. Pour une dérivation, l'estimation du courant non mesuré est ajoutée au courant mesuré à l'étape 202. Pour un point chaud à un compteur, l'estimation de la chute de tension observée est ajoutée à la tension mesurée à l'étape 202 pour le compteur. Pour un compteur suspecté de ne pas être rattaché au réseau, le compteur est retiré du lot de compteurs traités à l'étape 202. Pour un compteur suspecté d'être défectueux, sa mesure de tension peut être conservée si elle est jugée valide et le courant mesuré mis à zéro à l'étape 202 pour le compteur.

Si la mesure de tension n'est pas valide, le compteur est retiré du lot de compteurs à traiter. En mode automatique, le nombre d'itérations permises pour la modélisation des NCE à l'étape 238 peut être limité e.g. pour restreindre une durée d'exécution de la méthode dans un temps prescrit. La sortie de boucle peut alors se faire sans avoir atteint le seuil de précision vérifié à l'étape 236. En mode automatique, la modélisation des NCE à l'étape 238 peut être aléatoire par essai et erreur (e.g. méthode de recuit simulé ou "simulated annealing") en conservant le meilleur résultat ou un ensemble de certains meilleurs résultats pour une NCE à la fois, en ajoutant une nouvelle NCE après constat de la convergence des itérations. L'ajout des NCE modélisées à l'étape 202 peut être disposé en tout début du processus mais aussi plus loin comme avant le second calcul des dérivées discrètes de tension et de courant à l'étape 220. Une fois la précision atteinte ou un nombre d'itérations complétées, un diagnostic est réalisé à l'étape 240 à partir de dépassements de seuils et du tableau diagnostique inscrits dans la base de données 301. Si une NCE est détectée, différentes actions peuvent être commandées à l'étape 245, comme une inspection sur le terrain et, dans le cas d'un risque d'incendie par un point chaud, une transmission au compteur ciblé d'une commande d'interruption de service d'alimentation.

En référence à la Figure 15, il est illustré un système pouvant réaliser la méthode selon l'invention. Selon un arrangement physique de connectivité destiné à exécuter la méthode, un réseau de communication 300 fournissant des fonctions de communication, de contrôle et de commande, reçoit des mesures de consommation des compteurs intelligents 5 rattachés à la ligne basse tension 2 elle-même rattachée à la ligne moyenne tension 15 par le transformateur 3. Le réseau de communication 300 est doté d'équipements de communication (non illustrés) pouvant disposer d'une mémoire emmagasinant temporairement les mesures à transiter sous forme de données. Une unité de traitement 302, comprenant un processeur 303, une mémoire 304, une interface entrée/sortie 305 et de préférence une table relationnelle 309 pour anonymisation des données, est configurée pour recevoir les données (e.g. provenant des mesures de tension fournies par les compteurs 5) du réseau de communication 300 ou d'une base de données 301 pouvant conserver des historiques de mesures fournies par les compteurs 5, des tables relationnelles qui décrivent une topologie du réseau (e.g. appariements compteur-transformateur), des valeurs de seuils préétablis et une table diagnostique applicables à la méthode. Le tableau 2 qui suit fournit un exemple de table diagnostique.

| Tableau 2 - Table diagnostique | | | | | |
|---|---|---|---|---|---|
| | Compteur rattaché à un autre réseau | Contournement | Dérivation | Points chauds ou défaut de rattachement | Compteur défectueux |
| Fonction de transfert Symétrie | X | X | | X | X |
| Fonction de transfert Rangée < seuil | X | | | | X |
| Fonction de transfert Rangée > seuil | | X | | | X |
| Fonction de transfert Colonne < ou > seuil | | | | X | X |
| Fonction de transfert Dispersion > seuil | X | | | X | X |
| Matrice de corrélation Terme < seuil | X | | | X | X |
| Matrice de cohérence Terme < seuil | X | | | X | X |
| Écart de tension > seuil | | | X | X | X |
| Courant non mesuré >seuil | | | X | X | X |

Dans la table diagnostique, le terme "Dérivation" inclut une subtilisation par dérivation, une présence d'un compteur électromécanique ou d'un rattachement forfaitaire. Le terme "Rangée" signifie un ou des termes de la rangée (compteur parlant) associée à un compteur excluant le terme diagonal. Le terme "Colonne" signifie un ou des termes de la colonne (compteur écoutant) associée à un compteur excluant le terme diagonal. Une autre table diagnostique peut être utilisée pour des compteurs présentant des cycles de luminaires ou consommant peu. Des instructions décrivant des opérations à exécuter par le processeur 303 pour réaliser la méthode selon l'invention, e.g. sous forme de codes formant un programme ou une application, peuvent être chargées dans la mémoire 304 de l'unité de traitement 302. L'historique des tensions contenu dans la base de données 301 peut avoir été généré et déposé dans la mémoire 304 par le réseau 300 ou par l'unité de traitement 302. L'unité de traitement 302 peut être configurée par un terminal 306 connecté à l'unité de traitement 302 ou par des instructions de configuration via un réseau de communication 307 connecté à l'interface entrée/sortie 305. La méthode peut être démarrée manuellement par un utilisateur par exemple au moyen du terminal 306 ou par une configuration qui comprend entre autres un intervalle entre deux exécutions automatiques de la méthode. D'autres applications peuvent au travers du réseau de communication 307 consulter ou modifier la base de données 301, et plus particulièrement les tables relationnelles contenues dans la base de données 301. D'autres applications peuvent configurer la méthode dans l'unité de traitement 302 au travers du réseau de communication 307 relié à l'interface entrée/sortie 305 par exemple pour fixer ou ajuster les seuils ou utiliser des fonctions programmées utiles à la méthode selon l'invention. L'unité de traitement 302 peut débuter l'application/exécution de la méthode comme illustrée à la Figure 14 par une sélection d'un réseau basse tension 1 (comme illustré à la Figure 4) à contrôler et une quête des historiques des mesures des compteurs 5 afférents au réseau 1 sélectionné. La suite du traitement peut être réalisée dans l'unité de traitement 302 ou dans un nuage privé d'applications partagées 308 contenant des instructions pour réaliser la méthode ou une partie de la méthode. Dans ce dernier cas, les données transmise de l'unité de traitement 302 dans le nuage privé 308 sont de préférence anonymisées, par exemple en créant une table relationnelle 309 faisant un lien entre des identifiants clients et un identifiant anonyme des compteurs 5 de même que pour des identifiants réseaux basse tension 1 et pour des identifiants réseaux moyenne tension 15. Les résultats de la méthode peuvent être utilisés par d'autres méthodes ou applications déployées dans l'unité de traitement 302 ou dans le nuage privé 308, ou transmis pour affichage au terminal 306 ou transmis à tout autre système relié via le réseau de communication 307. L'affichage au terminal 306 ou sur un autre dispositif (non illustré) peut prendre la forme de l'IUG illustré à la Figure 13 et de diverses fenêtres de représentations graphiques comme discuté ci-dessus. Les actions à l'étape 245 (illustrée à la Figure 14) peuvent être transmises pour affichage au terminal 306 ou transmises à un autre système relié via le réseau de communication 307, ou encore transmises à un compteur 5 ciblé via le réseau de communication 300 dans le cas d'une commande d'interruption de service.

Quoique la méthode selon l'invention décrite ci-dessus réfère à plusieurs équations, il doit être compris que les équations en question décrivent et définissent des étapes, séquences, systèmes, algorithmes ou formes d'algorithmes qui, lorsqu'implémentées dans et par un ordinateur ou un système informatique, constituent une forme concrète de réalisation de l'invention. Bien que des réalisations de l'invention aient été illustrées dans les dessins ci-joints et décrites ci-dessus, il apparaîtra évident pour les personnes versées dans l'art que des modifications peuvent être apportées à ces réalisations sans s'écarter de l'invention. Par exemple, une sélection des compteurs 5 dans la méthode selon l'invention peut être un sous-ensemble des compteurs 5 attribués à un transformateur 3 selon les appariements dans la base de données 301, et d'autres peuvent être sélectionnés aussi. Un compteur 5 peut être exclu de la sélection lorsqu'il est, par exemple, soupçonné d'être défectueux, non rattaché au transformateur impliqué, ou tout en consommant peu d'énergie a un défaut de raccordement qui perturbe sa tension mesurée au point d'ajouter plus de bruit à la modélisation que de l'information. Un compteur 5 peut être ajouté à la sélection si le compteur provient d'un autre transformateur sur lequel il ne semble pas être rattaché, afin de tester l'appariement compteur-transformateur pour le transformateur 3 impliqué dans la méthode. Une meilleure modélisation confirme alors le nouvel appariement compteur-transformateur. Dans le cas où une mesure de tension est disponible au primaire du transformateur 3 raccordé au réseau 2, le transformateur 3 peut lui-même être considéré comme un compteur intelligent 5. Dans la méthode selon l'invention, il lui sera attribué un courant nul, et les termes de la colonne correspondante dans la matrice de fonction de transfert **H** seront placés par symétrie dans les termes de la rangée correspondante. Pour l'auto-terme, il sera fixé à une valeur égale à la valeur moyenne des inter-termes correspondant au noeud de référence, qui sont les plus petits termes de la matrice de fonction de transfert. La matrice de fonction de transfert **H** est ainsi corrigée en regard d'un courant nul. Une présentation et un examen des différentes grandeurs et indicateurs déterminés par la méthode en fonction du temps, d'une position dans une périodicité (heure du jour, jour de la semaine), en fonction de la température ou en fonction de la charge globale sont d'autres exemples de fonctions pouvant être implémentées dans la méthode et le système selon l'invention.

## Revendications

1. Une méthode mise en oeuvre par ordinateur pour détecter des anomalies dans un réseau électrique, la méthode comprenant les étapes de:

(i) récupérer des mesures de consommation produites par des compteurs présumés être rattachés à un même transformateur du réseau électrique d'après une topologie préétablie du réseau électrique, les mesures de consommation étant échelonnées dans le temps;

(ii) générer un modèle matriciel ohmique du réseau électrique, le modèle matriciel ohmique ayant pour input des courants transités par les compteurs, pour output des chutes de tension relative des compteurs référencées à une tension d'un noeud de référence situé sur le réseau électrique, et pour termes matriciels des grandeurs résistives déterminées initialement par des courants et des tensions basés sur les mesures de consommation, la tension relative étant une différence de tension entre une tension déterminée pour un des compteurs et une moyenne de tensions déterminées pour un ensemble de compteurs du réseau électrique;

(iii) effectuer aux moins une des opérations suivantes:

comparer les grandeurs résistives du modèle matriciel ohmique les unes aux autres selon des patrons de comparaison matricielle préétablis et par rapport à des seuils de grandeurs préétablies indicatifs d'anomalies;

déterminer une chute de tension relative instantanée d'un compteur basée sur les mesures de consommation du compteur et déterminer des écarts par rapport à la chute de tension relative instantanée estimée avec le modèle matriciel ohmique pour le compteur, les écarts dépassant un seuil préréglé étant indicatifs d'anomalies; et

générer un modèle matriciel inverse du modèle matriciel ohmique, le modèle matriciel inverse ayant pour input des écarts de chutes de tension relative instantanée des compteurs et pour output des courants non mesurés en fonction des écarts, les courants non mesurés dépassant un seuil préréglé étant indicatifs d'anomalies;

(iv) selon qu'une condition de modélisation préétablie du modèle matriciel ohmique est satisfaite ou non, retourner à l'étape (ii) en modifiant l'input et les grandeurs résistives en fonction des anomalies détectées à l'étape (iii); et

(v) fournir un diagnostic du réseau électrique caractérisant des anomalies détectées à l'étape (iii).

2. La méthode selon la revendication 1, dans laquelle les grandeurs résistives du modèle matriciel ohmique sont déterminées en fonction d'une somme de produits de dérivée de tension d'un premier compteur par des dérivées de courant d'un second compteur sur une somme de carrés de dérivées de courant du second compteur, les premier et second compteurs étant un même compteur pour déterminer un terme matriciel diagonal du modèle matriciel ohmique.

3. La méthode selon la revendication 2, dans laquelle les grandeurs résistives du modèle matriciel ohmique sont corrigées par un traitement d'optimisation itératif guidé par une réduction d'un écart quadratique entre des valeurs prédites par le modèle matriciel ohmique et des valeurs correspondantes dérivées des mesures de consommation.

4. La méthode selon la revendication 1, dans laquelle la tension dérivée des mesures de consommation d'un compteur est corrigées en fonction d'un facteur d'étalonnage préétabli.

5. La méthode selon la revendication 1, comprenant de plus l'étape de, entre les étapes (ii) et (iv):
déterminer une dispersion du modèle matriciel ohmique de manière à déterminer des valeurs d'aléas des grandeurs résistives du modèle matriciel ohmique;
et dans laquelle un des patrons de comparaison matricielle comprend une répartition des valeurs d'aléas dans le modèle matriciel ohmique et un des seuils de grandeurs préétablies comprend une valeur d'aléa.

6. La méthode selon la revendication 1, comprenant de plus l'étape de, entre les étapes (ii) et (iv):
générer une matrice de corrélation entre les tensions et les courants des compteurs;
et dans laquelle un des patrons de comparaison matricielle comprend une répartition de valeurs de corrélation dans la matrice de corrélation et un des seuils de grandeurs préétablies comprend une valeur de corrélation.

7. La méthode selon la revendication 1, comprenant de plus l'étape de, entre les étapes (ii) et (iv):
générer une matrice de cohérence entre les tensions et les courants des compteurs;
et dans laquelle un des patrons de comparaison matricielle comprend une répartition de valeurs de cohérence dans la matrice de cohérence et un des seuils de grandeurs préétablies comprend une valeur de cohérence.

8. La méthode selon la revendication 1, dans laquelle les mesures de consommation où les écarts déterminés excèdent un seuil de grandeur préétabli sont retirées avant l'étape (iv).

9. La méthode selon la revendication 1, dans laquelle la condition de modélisation préétablie comprend une réduction d'un écart quadratique entre des valeurs prédites par le modèle matriciel ohmique et des valeurs correspondantes dérivées des mesures de consommation.

10. La méthode selon la revendication 1, dans laquelle le noeud de référence est un raccordement d'un des compteurs ou une jonction de ligne du réseau électrique ou une source génératrice de puissance du réseau électrique.

11. La méthode selon la revendication 1, dans laquelle les patrons de comparaison matricielle préétablis comprennent une symétrie des inter-termes matriciels par rapport à une diagonale formée par des auto-termes du modèle matriciel ohmique.

12. La méthode selon la revendication 1, dans laquelle le diagnostic est affiché dans une interface utilisateur graphique ayant des composants interactifs de commande et de contrôle de séquences et paramètres de la méthode.

13. Un système pour détecter des anomalies dans un réseau électrique, le système comprenant une unité de traitement ayant un processeur et une mémoire en communication avec le processeur, la mémoire contenant des instructions qui, lorsqu'exécutées par le processeur, entraîne le processeur à réaliser les étapes de:

(i) récupérer des mesures de consommation produites par des compteurs présumés être rattachés à un même transformateur du réseau électrique d'après une topologie préétablie du réseau électrique, les mesures de consommation étant échelonnées dans le temps;

(ii) générer un modèle matriciel ohmique du réseau électrique, le modèle matriciel ohmique ayant pour input des courants transités par les compteurs, pour output des chutes de tension relative des compteurs référencées à une tension d'un noeud de référence situé sur le réseau électrique, et pour termes matriciels des grandeurs résistives déterminées initialement par des courants et des tensions basés sur les mesures de consommation, la tension relative étant une différence de tension entre une tension déterminée pour un des compteurs et une moyenne de tensions déterminées pour un ensemble de compteurs du réseau électrique;

(iii) effectuer aux moins une des opérations suivantes:

comparer les grandeurs résistives du modèle matriciel ohmique les unes aux autres selon des patrons de comparaison matricielle préétablis et par rapport à des seuils de grandeurs préétablies indicatifs d'anomalies;

déterminer une chute de tension relative instantanée d'un compteur basée sur les mesures de consommation du compteur et déterminer des écarts par rapport à la chute de tension relative instantanée estimée avec le modèle matriciel ohmique pour le compteur, les écarts dépassant un seuil préréglé étant indicatifs d'anomalies; et

générer un modèle matriciel inverse du modèle matriciel ohmique, le modèle matriciel inverse ayant pour input des écarts de chutes de tension relative instantanée des compteurs et pour output des courants non mesurés en fonction des écarts, les courants non mesurés dépassant un seuil préréglé étant indicatifs d'anomalies;

(iv) selon qu'une condition de modélisation préétablie du modèle matriciel ohmique est satisfaite ou non, retourner à l'étape (ii) en modifiant l'input et les grandeurs résistives en fonction des anomalies détectées à l'étape (iii); et

(v) fournir un diagnostic du réseau électrique caractérisant des anomalies détectées à l'étape (iii).

14. Le système selon la revendication 13, comprenant de plus un écran connecté au processeur, les instructions comprenant des instructions entraînant le processeur à afficher à l'écran une interface utilisateur graphique ayant des composants interactifs de commande et de contrôle de séquences et paramètres des étapes que le système réalise.

15. Un produit tangible et non transitoire de programme informatique pour détecter des anomalies dans un réseau électrique, contenant des instructions qui, lorsqu'exécutées par un processeur, entraîne le processeur à réaliser les étapes de:

(i) récupérer des mesures de consommation produites par des compteurs présumés être rattachés à un même transformateur du réseau électrique d'après une topologie préétablie du réseau électrique, les mesures de consommation étant échelonnées dans le temps;

(ii) générer un modèle matriciel ohmique du réseau électrique, le modèle matriciel ohmique ayant pour input des courants transités par les compteurs, pour output des chutes de tension relative des compteurs référencées à une tension d'un noeud de référence situé sur le réseau électrique, et pour termes matriciels des grandeurs résistives déterminées initialement par des courants et des tensions basés sur les mesures de consommation, la tension relative étant une différence de tension entre une tension déterminée pour un des compteurs et une moyenne de tensions déterminées pour un ensemble de compteurs du réseau électrique;

(iii) effectuer aux moins une des opérations suivantes:

comparer les grandeurs résistives du modèle matriciel ohmique les unes aux autres selon des patrons de comparaison matricielle préétablis et par rapport à des seuils de grandeurs préétablis indicatifs d'anomalies;

déterminer une chute de tension relative instantanée d'un compteur basée sur les mesures de consommation du compteur et déterminer des écarts par rapport à la chute de tension relative instantanée estimée avec le modèle matriciel ohmique pour le compteur, les écarts dépassant un seuil préréglé étant indicatifs d'anomalies; et

générer un modèle matriciel inverse du modèle matriciel ohmique, le modèle matriciel inverse ayant pour input des écarts de chutes de tension relative instantanée des compteurs et pour output des courants non mesurés en fonction des écarts, les courants non mesurés dépassant un seuil préréglé étant indicatifs d'anomalies;

(iv) selon qu'une condition de modélisation préétablie du modèle matriciel ohmique est satisfaite ou non, retourner à l'étape (ii) en modifiant l'input et les grandeurs résistives en fonction des anomalies détectées à l'étape (iii); et

(v) fournir un diagnostic du réseau électrique caractérisant des anomalies détectées à l'étape (iii).

**Patentansprüche**

1. Verfahren, das von einem Computer durchgeführt wird, um Anomalien in einem Stromnetz zu erfassen, wobei das Verfahren folgende Schritte enthält:

(i) Abrufen von Verbrauchsmesswerten, die von Zählern erzeugt werden, von denen angenommen wird, dass sie gemäß einer vorab erstellten Topologie des Stromnetzes zu einem gleichen Transformator des Stromnetzes gehören, wobei die Verbrauchsmesswerte zeitlich gestaffelt sind;

(ii) Generieren eines ohmschen Matrixmodells des Stromnetzes, wobei das ohmsche Matrixmodell als Input durch die Zähler gehende Ströme, als Output relative Spannungsabfälle der Zähler bezüglich einer Spannung eines im Stromnetz befindlichen Bezugsknotens und als Matrixterme Widerstandsgrößen hat, die ursprünglich durch Ströme und Spannungen basierend auf den Verbrauchsmesswerten bestimmt werden, wobei die relative Spannung ein Spannungsunterschied zwischen einer für einen der Zähler bestimmten Spannung und einem Mittelwert für eine Gruppe von Zählern des Stromnetzes bestimmten Spannungen ist;

(iii) Ausführen mindestens einer der folgenden Operationen:

Vergleichen der Widerstandsgrößen des ohmschen Matrixmodells miteinander gemäß vorab erstellten Matrixvergleichsmustern und bezüglich von Anomalien anzeigenden Schwellen vorab erstellter Größen;

Bestimmen eines augenblicklichen relativen Spannungsabfalls eines Zählers basierend auf den Verbrauchsmesswerten des Zählers und Bestimmen von Abweichungen bezüglich des geschätzten augenblicklichen relativen Spannungsabfalls mit dem ohmschen Matrixmodell für den Zähler, wobei die eine voreingestellte Schwelle überschreitenden Abweichungen Anomalien anzeigen; und

Generieren eines inversen Matrixmodells des ohmschen Matrixmodells, wobei das inverse Matrixmodell als Input Abweichungen von augenblicklichen relativen Spannungsabfällen der Zähler und als Output nicht gemessene Ströme abhängig von den Abweichungen hat, wobei die eine voreingestellte Schwelle überschreitenden nicht gemessenen Ströme Anomalien anzeigen;

(iv) je nachdem, ob eine vorab erstellte Modellierungsbedingung des ohmschen Matrixmodells erfüllt ist oder nicht, Rückkehr zum Schritt (ii) unter Änderung des Inputs und der Widerstandsgrößen abhängig von den im Schritt (iii) erfassten Anomalien; und

(v) Liefern einer Diagnose des Stromnetzes, die im Schritt (iii) erfasste Anomalien kennzeichnet.

2. Verfahren nach Anspruch 1, wobei die Widerstandsgrößen des ohmschen Matrixmodells abhängig von einer Summe von Spannungsableitungsprodukten eines ersten Zählers durch Stromableitungen eines zweiten Zählers über eine Summe von Quadraten von Stromableitungen des zweiten Zählers bestimmt werden, wobei der erste und der zweite Zähler ein gleicher Zähler sind, um einen diagonalen Matrixterm des ohmschen Matrixmodells zu bestimmen.

3. Verfahren nach Anspruch 2, wobei die Widerstandsgrößen des ohmschen Matrixmodells durch eine geführte iterative Optimierungsverarbeitung durch eine Reduzierung einer quadratischen Abweichung zwischen vom ohmschen Matrixmodell vorhergesagten Werten und entsprechenden von den Verbrauchsmesswerten abgeleiteten Werten korrigiert werden.

4. Verfahren nach Anspruch 1, wobei die von den Verbrauchsmesswerten eines Zählers abgeleitete Spannung abhängig von einem vorab erstellten Kalibrierungsfaktor korrigiert wird.

5. Verfahren nach Anspruch 1, das außerdem zwischen den Schritten (ii) und (iv) den Schritt enthält:

Bestimmen einer Streuung des ohmschen Matrixmodells, um Werte von Zufallszahlen der Widerstandsgrößen des ohmschen Matrixmodells zu bestimmen;
und wobei eines der Matrixvergleichsmuster eine Verteilung der Werte von Zufallszahlen im ohmschen Matrixmodell enthält, und eine der Schwellen von vorab erstellten Größen einen Zufallszahlenwert enthält.

6. Verfahren nach Anspruch 1, das außerdem zwischen den Schritten (ii) und (iv) den Schritt enthält:

Generieren einer Korrelationsmatrix zwischen den Spannungen und den Strömen der Zähler;
und wobei eines der Matrixvergleichsmuster eine Verteilung von Korrelationswerten in der Korrelationsmatrix enthält, und eine der Schwellen von vorab erstellten Größen einen Korrelationswert enthält.

7. Verfahren nach Anspruch 1, das außerdem zwischen den Schritten (ii) und (iv) den Schritt enthält:

Generieren einer Kohärenzmatrix zwischen den Spannungen und den Strömen der Zähler;
und wobei eines der Matrixvergleichsmuster eine Verteilung von Kohärenzwerten in der Kohärenzmatrix enthält, und eine der Schwellen von vorab erstellten Größen einen Kohärenzwert enthält.

8. Verfahren nach Anspruch 1, wobei die Verbrauchsmesswerte, bei denen die bestimmten Abweichungen eine vorab erstellte Größenschwelle überschreiten, vor dem Schritt (iv) entfernt werden.

9. Verfahren nach Anspruch 1, wobei die vorab erstellte Modellierungsbedingung eine Reduzierung einer quadratischen Abweichung zwischen vom ohmschen Matrixmodell vorhergesagten Werten und entsprechenden von den Verbrauchsmesswerten abgeleiteten Werten enthält.

10. Verfahren nach Anspruch 1, wobei der Bezugsknoten ein Anschluss eines der Zähler oder ein Leitungsanschluss des Stromnetzes oder eine leistungserzeugende Quelle des Stromnetzes ist.

11. Verfahren nach Anspruch 1, wobei die vorab erstellten Matrixvergleichsmuster eine Symmetrie der Matrix-Inter-Terme bezüglich einer von Auto-Termen des ohmschen Matrixmodells geformten Diagonalen enthalten.

12. Verfahren nach Anspruch 1, wobei die Diagnose in einer grafischen Benutzerschnittstelle angezeigt wird, die interaktive Komponenten der Steuerung und Kontrolle von Sequenzen und Parametern des Verfahrens hat.

13. System zur Erfassung von Anomalien in einem Stromnetz, wobei das System eine Verarbeitungseinheit enthält, die einen Prozessor und einen mit dem Prozessor in Verbindung stehenden Speicher hat, wobei der Speicher Anweisungen enthält, die, wenn sie von dem Prozessor ausgeführt werden, den Prozessor veranlassen, die folgenden Schritte durchzuführen:

(i) Abrufen von Verbrauchsmesswerten, die von Zählern produziert werden, von denen angenommen wird, dass sie gemäß einer vorab erstellten Topologie des Stromnetzes zu einem gleichen Transformator des Stromnetzes gehören, wobei die Verbrauchsmesswerte zeitlich gestaffelt sind;

(ii) Generieren eines ohmschen Matrixmodells des Stromnetzes, wobei das ohmsche Matrixmodell als Input durch die Zähler gehende Ströme, als Output relative Spannungsabfälle der Zähler, die sich auf eine Spannung eines im Stromnetz befindlichen Bezugsknotens beziehen, und als Matrixterme Widerstandsgrößen hat, die ursprünglich durch Ströme und Spannungen basierend auf den Verbrauchsmesswerten bestimmt werden, wobei die relative Spannung ein Spannungsunterschied zwischen einer bestimmten Spannung für einen der Zähler und einem Mittelwert bestimmter Spannungen für eine Gruppe von Zählern des Stromnetzes ist;

(iii) Ausführen mindestens einer der folgenden Operationen:

Vergleichen der Widerstandsgrößen des ohmschen Matrixmodells miteinander gemäß vorab erstellten Matrixvergleichsmustern und bezüglich von Anomalien anzeigenden Schwellen von vorab erstellten Größen;

Bestimmen eines augenblicklichen relativen Spannungsabfalls eines Zählers basierend auf den Verbrauchsmesswerten des Zählers und Bestimmen von Abweichungen bezüglich des geschätzten augenblicklichen relativen Spannungsabfalls mit dem ohmschen Matrixmodell für den Zähler, wobei die eine vorab eingestellte Schwelle überschreitenden Abweichungen Anomalien anzeigen; und

Generieren eines inversen Matrixmodells des ohmschen Matrixmodells, wobei das inverse Matrixmodell als Input Abweichungen von augenblicklichen relativen Spannungsabfällen der Zähler und als Output nicht gemessene Ströme abhängig von den Abweichungen hat, wobei die eine vorab eingestellte Schwelle überschreitenden nicht gemessenen Ströme Anomalien anzeigen;

(iv) je nachdem, ob eine vorab erstellte Modellierungsbedingung des ohmschen Matrixmodells erfüllt ist oder nicht, Rückkehr zum Schritt (ii) unter Änderung des Inputs und der Widerstandsgrößen abhängig von den im Schritt (iii) erfassten Anomalien; und

(v) Liefern einer Diagnose des Stromnetzes, die im Schritt (iii) erfasste Anomalien kennzeichnet.

14. System nach Anspruch 13, das außerdem einen mit dem Prozessor verbundenen Bildschirm enthält, wobei die Anweisungen Anweisungen enthalten, die den Prozessor veranlassen, auf dem Bildschirm eine grafische Benutzerschnittstelle anzuzeigen, die interaktive Steuer- und Kontrollkomponenten von Sequenzen und Parametern der Schritte hat, die das System durchführt.

15. Tangibles und nicht transitorisches Produkt eines EDV-Programms zur Erfassung von Anomalien in einem Stromnetz, das Anweisungen enthält, die, wenn sie von einem Prozessor ausgeführt werden, den Prozessor veranlassen, die folgenden Schritte durchzuführen:

(i) Abrufen von Verbrauchsmesswerten, die von Zählern erzeugt werden, von denen angenommen wird, dass sie gemäß einer vorab erstellten Topologie des Stromnetzes zu einem gleichen Transformator des Stromnetzes gehören, wobei die Verbrauchsmesswerte zeitlich gestaffelt sind;

(ii) Generieren eines ohmschen Matrixmodells des Stromnetzes, wobei das ohmsche Matrixmodell als Input durch die Zähler gehende Ströme, als Output relative Spannungsabfälle der Zähler, die sich auf eine Spannung eines im Stromnetz befindlichen Bezugsknotens beziehen, und als Matrixterme Widerstandsgrößen hat, die ursprünglich durch Ströme und Spannungen basierend auf den Verbrauchsmesswerten bestimmt werden, wobei die relative Spannung ein Spannungsunterschied zwischen einer bestimmten Spannung für einen der Zähler und einem Mittelwert bestimmter Spannungen für eine Gruppe von Zählern des Stromnetzes ist;

(iii) Ausführen mindestens einer der folgenden Operationen:

Vergleichen der Widerstandsgrößen des ohmschen Matrixmodells miteinander gemäß vorab erstellten Matrixvergleichsmustern und bezüglich von Anomalien anzeigenden Schwellen von vorab erstellten Größen;

Bestimmen eines augenblicklichen relativen Spannungsabfalls eines Zählers basierend auf den Verbrauchsmesswerten des Zählers und Bestimmen von Abweichungen bezüglich des geschätzten augenblicklichen relativen Spannungsabfalls mit dem ohmschen Matrixmodell für den Zähler, wobei die eine vorab eingestellte Schwelle überschreitenden Abweichungen Anomalien anzeigen; und

Generieren eines inversen Matrixmodells des ohmschen Matrixmodells, wobei das inverse Matrixmodell als Input Abweichungen von augenblicklichen relativen Spannungsabfällen der Zähler und als Output nicht gemessene Ströme abhängig von den Abweichungen hat, wobei die eine vorab eingestellte Schwelle überschreitenden nicht gemessenen Ströme Anomalien anzeigen;

(iv) je nachdem, ob eine vorab erstellte Modellierungsbedingung des ohmschen Matrixmodells erfüllt ist oder nicht, Rückkehr zum Schritt (ii) unter Änderung des Inputs und der Widerstandsgrößen abhängig von den im Schritt (iii) erfassten Anomalien; und

(v) Liefern einer Diagnose des Stromnetzes, die im Schritt (iii) erfasste Anomalien kennzeichnet.

**Claims**

1. A computer implemented method for detecting anomalies in an electrical network, the method comprising the steps of:

   (i) retrieving consumption measurements produced by meters presumed to be connected to a same transformer of the electrical network based on a preestablished topology of the electrical network, the consumption measurements being distributed through time;
   (ii) generating an ohmic matrix model of the electrical network, the ohmic matrix model having currents carried by the meters as input, relative voltage drops of the meters referenced to a voltage of a reference node located on the electrical network as output, and resistive quantities initially determined by currents and voltages based on consumption measurements as matrix terms, the relative voltage being a voltage difference between a voltage determined for one of the meters and an average of voltages determined for a set of meters of the electrical network;
   (iii) performing at least one of the following operations:

   comparing the resistive quantities of the ohmic matrix model with one another according to preestablished matrix comparison patterns and with respect to preestablished quantity thresholds indicative of anomalies;
   determining an instantaneous relative voltage drop of a meter based on the consumption measurements of the meter and determining deviations with respect to the instantaneous relative voltage drop estimated with the ohmic matrix model for the meter, the deviations exceeding a preset threshold being indicative of anomalies; and
   generating an inverse matrix model of the ohmic matrix model, the inverse matrix model having deviations of instantaneous relative voltage drops of the meters as input and unmetered currents as a function of the deviations as output, the unmetered currents exceeding a preset threshold being indicative of anomalies;

   (iv) depending on whether a preestablished modeling condition of the ohmic matrix model is satisfied or not, returning to step (ii) while modifying the input and the resistive quantities as a function of the anomalies detected at step (iii); and
   (v) providing a diagnosis of the electrical network characterizing the anomalies detected at step (iii).

2. The method according to claim 1, wherein the resistive quantities of the ohmic matrix model are determined as a function of a sum of products of voltage derivative of a first meter by derivatives of current of a second meter over a sum of squares of derivatives of current of the second meter, the first and second meters being a same meter to determine a diagonal matrix term of the ohmic matrix model.

3. The method according to claim 2, wherein the resistive quantities of the ohmic matrix model are corrected by an iterative optimization process guided by a reduction of a standard deviation between values predicted by the ohmic matrix model and corresponding values derived from the consumption measurements.

4. The method according to claim 1, wherein the voltage derived from the consumption measurements of a meter is corrected as a function of a preestablished calibration factor.

5. The method according to claim 1, further comprising the step of, between steps (ii) and (iv):
   determining a dispersion of the ohmic matrix model to determine fluctuation values of the resistive quantities of the ohmic matrix model;
   and wherein one of the matrix comparison patterns comprises a distribution of the fluctuation values in the ohmic matrix model and one of the preestablished quantity thresholds comprises a fluctuation value.

6. The method according to claim 1, further comprising the step of, between steps (ii) and (iv):
   generating a correlation matrix between the voltages and the currents of the meters;
   and wherein one of the matrix comparison patterns comprises a distribution of correlation values in the correlation matrix and one of the preestablished quantity thresholds comprises a correlation value.

7. The method according to claim 1, further comprising the step of, between steps (ii) and (iv):
generating a coherence matrix between the voltages and the currents of the meters;
and wherein one of the matrix comparison patterns comprises a distribution of coherence values in the coherence matrix and one of the preestablished quantity thresholds comprises a coherence value.

8. The method according to claim 1, wherein the consumption measurements where the deviations determined exceed a preestablished quantity threshold are removed prior to step (iv).

9. The method according to claim 1, wherein the preestablished modeling condition comprises a reduction of a standard deviation between values predicted by the ohmic matrix model and corresponding values derived from the consumption measurements.

10. The method according to claim 1, wherein the reference node is a connection of one of the meters or a line junction of the electrical network or a power generating source of the electrical network.

11. The method according to claim 1, wherein the preestablished matrix comparison patterns comprise a symmetry of the matrix inter-terms with respect to a diagonal formed by auto-terms of the ohmic matrix model.

12. The method according to claim 1, wherein the diagnosis is displayed in a graphical user interface having interactive components of command and of control of sequences and parameters of the method.

13. A system for detecting anomalies in an electrical network, the system comprising a processing unit having a processor and a memory in communication with the processor, the memory storing instructions that, when executed by the processor, cause the processor to perform the steps of:

(i) retrieving consumption measurements produced by meters presumed to be connected to a same transformer of the electrical network based on a preestablished topology of the electrical network, the consumption measurements being distributed through time;
(ii) generating an ohmic matrix model of the electrical network, the ohmic matrix model having currents carried by the meters as input, relative voltage drops of the meters referenced to a voltage of a reference node located on the electrical network as output, and resistive quantities initially determined by currents and voltages based on consumption measurements as matrix terms, the relative voltage being a voltage difference between a voltage determined for one of the meters and an average of voltages determined for a set of meters of the electrical network;
(iii) performing at least one of the following operations:

comparing the resistive quantities of the ohmic matrix model with one another according to preestablished matrix comparison patterns and with respect to preestablished quantity thresholds indicative of anomalies;
determining an instantaneous relative voltage drop of a meter based on the consumption measurements of the meter and determining deviations with respect to the instantaneous relative voltage drop estimated with the ohmic matrix model for the meter, the deviations exceeding a preset threshold being indicative of anomalies; and
generating an inverse matrix model of the ohmic matrix model, the inverse matrix model having deviations of instantaneous relative voltage drops of the meters as input and unmetered currents as a function of the deviations as output, the unmetered currents exceeding a preset threshold being indicative of anomalies;

(iv) depending on whether a preestablished modeling condition of the ohmic matrix model is satisfied or not, returning to step (ii) while modifying the input and the resistive quantities as a function of the anomalies detected at step (iii); and
(v) providing a diagnosis of the electrical network characterizing the anomalies detected at step (iii).

14. The system according to claim 13, further comprising a screen connected to the processor, the instructions comprising instructions causing the processor to display on the screen a graphical user interface having interactive components of command and control of sequences and parameters of the steps that the system performs.

15. A non-transitory tangible computer program product for detecting anomalies in an electrical network, storing instructions that, when executed by a processor, cause the processor to perform the steps of:

(i) retrieving consumption measurements produced by meters presumed to be connected to a same transformer of the electrical network based on a preestablished topology of the electrical network, the consumption measurements being distributed through time;

(ii) generating an ohmic matrix model of the electrical network, the ohmic matrix model having currents carried by the meters as input, relative voltage drops of the meters referenced to a voltage of a reference node located on the electrical network as output, and resistive quantities initially determined by currents and voltages based on consumption measurements as matrix terms, the relative voltage being a voltage difference between a voltage determined for one of the meters and an average of voltages determined for a set of meters of the electrical network as matrix terms;

(iii) performing at least one of the following operations:

comparing the resistive quantities of the ohmic matrix model with one another according to preestablished matrix comparison patterns and with respect to preestablished quantity thresholds indicative of anomalies;

determining an instantaneous relative voltage drop of a meter based on the consumption measurements of the meter and determining deviations with respect to the instantaneous relative voltage drop estimated with the ohmic matrix model for the meter, the deviations exceeding a preset threshold being indicative of anomalies; and

generating an inverse matrix model of the ohmic matrix model, the inverse matrix model having deviations of instantaneous relative voltage drops of the meters as input and unmetered currents as a function of the deviations as output, the unmetered currents exceeding a preset threshold being indicative of anomalies;

(iv) depending on whether a preestablished modeling condition of the ohmic matrix model is satisfied or not, returning to step (ii) while modifying the input and the resistive quantities as a function of the anomalies detected at step (iii); and

(v) providing a diagnosis of the electrical network characterizing the anomalies detected at step (iii).

FIG. 1

FIG. 2

FIG. 3

FIG. 4

FIG. 5A

FIG. 5B

FIG. 6

FIG. 7

FIG. 8

FIG. 9A

FIG. 9B

FIG. 10

FIG. 11A

FIG. 11B

Tension relative mesurée - tension relative estimée △

## FIG. 12A

## FIG. 12B

FIG. 13

Série de valeurs discrètes
200

Ajout de NCE modélisées
202

Détection et retrait
d'anomalies majeures
204

Calcul des dérivées discrètes
206

Matrice ohmique
208

$\Delta v'_{i,m}$
210

$\Delta vv_{i,m}$
212

214 −

$\Delta\Delta v_{i,m}$
215

Détection et retrait
d'anomalies mineures
216

Calcul des dérivées discrètes
220

222
Matrice ohmique

224
$\alpha$

$\Delta v'_{i,m}$
226

$\Delta vv_{i,m}$
228

230

$\Delta\Delta v_{i,m}$
231

Calcul des courants non
mesurés
232

Calcul des indicateurs
234

238
Modélisation de NCE

Non

Précision
atteinte ?
236

Oui

Diagnostic
240

Actions
245

FIG. 14

FIG. 15

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20100007336 A, Buda
- US 20140236506 A
- US 20140368189 A, Bernheim
- US 20150241488 A, Sonderegger
- US 20160035049 A, Vinodini
- US 20160054364 A, Chen
- US 20160117326 A, Steigler
- US 2016320431 A, Driscoll
- US 6633823 B, Bartone
- US 7936163 B, Lee
- US 7986246 B, Angelis
- US 8818742 B, Ansari
- US 9013173 B, Veillette
- US 9122618 B, Hugues
- WO 2013086631 A, Hughes
- WO 2016049369 A, Siebel
- EP 2869422 A, Maximini
- US 20090281679 A, Taft
- US 20140317258 A, Riley
- US 20150149128 A, Baone
- US 20150278410 A, Kumar
- US 9094430 B, Wang
- US 9189822 B, Conant
- US 9214836 B, Flammer
- US 9285242 B, Arya
- WO 2014130366 A, Hansell
- WO 2014185921 A, Marinakis
- WO 2015120141 A, Shima
- WO 2015130819 A
- WO 2017100916 A, Léonard
- CA 2017050448 W, Léonard